(19) Europäisches Patentamt
European Patent Office
Office européen des brevets

(11) EP 3 216 596 A1

(12) EUROPEAN PATENT APPLICATION
published in accordance with Art. 153(4) EPC

(43) Date of publication:
**13.09.2017 Bulletin 2017/37**

(21) Application number: **15869803.5**

(22) Date of filing: **02.12.2015**

(51) Int Cl.:
***B32B 7/02*** *(2006.01)* ***B32B 27/18*** *(2006.01)*
***B32B 27/36*** *(2006.01)* ***H01L 41/193*** *(2006.01)*

(86) International application number:
**PCT/JP2015/083918**

(87) International publication number:
**WO 2016/098597 (23.06.2016 Gazette 2016/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **17.12.2014 JP 2014255014**

(71) Applicant: **Mitsui Chemicals, Inc.**
**Minato-ku**
**Tokyo 105-7122 (JP)**

(72) Inventors:
- **TANIMOTO, Kazuhiro**
**Nagoya-shi**
**Aichi 457-8522 (JP)**
- **YOSHIDA, Mitsunobu**
**Nagoya-shi**
**Aichi 457-8522 (JP)**
- **NISHIKAWA, Shigeo**
**Nagoya-shi**
**Aichi 457-8522 (JP)**

(74) Representative: **Hoffmann Eitle**
**Patent- und Rechtsanwälte PartmbB**
**Arabellastraße 30**
**81925 München (DE)**

# (54) LAMINATED BODY

(57) A layered body including: a crystalline polymeric piezoelectric body having a standardized molecular orientation MORc of from 2.0 to 10.0 measured by a microwave transmission-type molecular orientation meter based on a reference thickness of 50 μm; and a surface layer which is disposed so that at least a part of the surface layer contacts the crystalline polymeric piezoelectric body, which has a surface resistivity of from $1\times10^6$ Ω/sq to $1\times10^{12}$ Ω/sq, and which contains an electroconductive material (A) and a polymer (B).



Printed by Jouve, 75001 PARIS (FR)

## Description

TECHNICAL FIELD

The present invention relates to a layered body.

BACKGROUND ART

Recently, a polymeric piezoelectric material using a helical chiral polymer having optical activity (e.g., polylactic acid-based polymer) has been reported.

For example, a polymeric piezoelectric material, which is prepared by stretching a formed product of polylactic acid and exhibits a piezoelectric modulus of approximately 10 pC/N at normal temperature, has been disclosed (for example, refer to Patent Literature 1 below).

Further, it has also been reported that in order to achieve high orientation of a polylactic acid crystal, a special orientation method called as a forging method is used, whereby piezoelectricity as high as approximately 18 pC/N is achieved (for example, refer to Patent Literature 2).

Further, a touch panel using a polylactic acid film having molecular orientation, and a touch input device using the touch panel have been also known (for example, refer to Patent Literature 3).

Further, as a layered body in which a decrease in sensitivity is suppressed or a layered body superior in adherence between a polymeric piezoelectric body and a surface layer, a layered body which has a polymeric piezoelectric body including a helical chiral polymer having optical activity and a specific surface layer has been known (for example, refer to Patent Literature 4).

Patent Literature 1: Japanese Patent Application Laid-Open (JP-A) No. H05-152638
Patent Literature 2: JP-A No. 2005-213376
Patent Literature 3: PCT International Publication No. WO 2010/143528
Patent Literature 4: PCT International Publication No. WO 2014/168188

DISCLOSURE OF INVENTION

TECHNICAL PROBLEM

Incidentally, the surface of the polymeric piezoelectric material (polymeric piezoelectric body) is easily damaged.

Thus, in order to protect the surface of the polymeric piezoelectric body and improve the scratch resistance, a surface layer referred to as "hard coat layer" may be layered on the polymeric piezoelectric body.

In this case, it is preferable that the piezoelectricity of the layered body having a polymeric piezoelectric body and a surface layer is maintained at high level.

Based on the study by the inventors, it has been found that static electricity derived from friction or static electricity derived from piezoelectricity tends to occur on the polymeric piezoelectric body.

Thus, the productivity in the process can be reduced by static electricity itself which occurs on the polymeric piezoelectric body or adhesion of dust to the polymeric piezoelectric body by static electricity. In a case in which the polymeric piezoelectric body is actually used as a piezoelectric device, a defect in appearance of the piezoelectric device or a decrease in performance of the piezoelectric device can be caused by static electricity itself which occurs on the polymeric piezoelectric body or adhesion of dust to the polymeric piezoelectric body by static electricity.

A method of incorporating an antistatic agent into the polymeric piezoelectric body (for example, by a mixing or kneading procedure) to improve the antistatic properties of the polymeric piezoelectric body is contemplated as a method of improving the problem of static electricity.

However, in the method of incorporating an antistatic agent into the polymeric piezoelectric body, there are possibilities that the transparency of the polymeric piezoelectric body is reduced or the antistatic agent is bled out with time due to bad compatibility between the polymeric piezoelectric body and the antistatic agent.

The invention has been achieved in view of the above circumstances.

That is, an object of the invention is to provide a layered body in which scratch resistance and antistatic properties are improved while the piezoelectricity is maintained at high level and the transparency is also maintained at high level to some extent.

SOLUTION TO PROBLEM

Specific means for achieving the object are as follow.

<1> A layered body comprising:

a crystalline polymeric piezoelectric body having a standardized molecular orientation MORc of from 2.0 to 10.0 measured by a microwave transmission-type molecular orientation meter based on a reference thickness of 50 μm; and
a surface layer which is disposed so that at least a part of the surface layer contacts the crystalline polymeric piezoelectric body, which has a surface resistivity of from $1\times10^6$ Ω/sq to $1\times10^{12}$ Ω/sq, and which contains an electroconductive material (A) and a polymer (B).

<2> The layered body according to <1>, wherein the electroconductive material (A) is an electroconductive polymer, and the polymer (B) is a polymer other than an electroconductive polymer.
<3> The layered body according to <1> or <2>, wherein a content of the electroconductive material (A) in the surface layer is from 0.01% by mass to 30% by mass.
<4> The layered body according to <2>, wherein the electroconductive polymer is at least one polymer selected from the group consisting of polythiophene, polythiophene derivatives, polypyrrole, polypyrrole derivatives, polyaniline, and polyaniline derivatives.
<5> The layered body according to any one of <1> to <4>, wherein a thickness of the surface layer is from 0.01 μm to 10 μm.
<6> The layered body according to any one of <1> to <5>, wherein the polymer (B) is a polymer having a three-dimensionally cross-linked structure.
<7> The layered body according to any one of <1> to <6>, wherein an internal haze with respect to visible light is 50% or less, and a piezoelectric constant $d_{14}$ measured at 25°C by a stress-electric charge method is 1 pC/N or more.
<8> The layered body according to any one of <1> to <7>, wherein an internal haze with respect to visible light is 13% or less.
<9> The layered body according to any one of <1> to <8>, wherein a product of the standardized molecular orientation MORc of the crystalline polymeric piezoelectric body and a crystallinity of the crystalline polymeric piezoelectric body obtained by a DSC method is from 40 to 700.
<10> The layered body according to any one of <1> to <9>, wherein the crystalline polymeric piezoelectric body includes a helical chiral polymer having optical activity and having a weight-average molecular weight of from 50,000 to 1,000,000, and has a crystallinity obtained by a DSC method of from 20% to 80%.
<11> The layered body according to <10>, wherein the helical chiral polymer is a polylactic acid-based polymer having a main chain including a repeating unit represented by the following Formula (1):

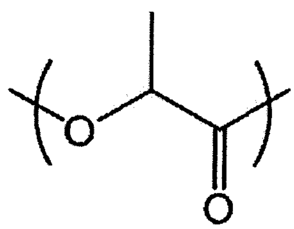

(1)

.

<12> The layered body according to <10> or <11>, wherein an optical purity of the helical chiral polymer is 95.00% ee or higher.
<13> The layered body according to any one of <10> to <12>, wherein a content of the helical chiral polymer in the crystalline polymeric piezoelectric body is 80% by mass or more.
<14> The layered body according to any one of <10> to <13>, wherein the crystalline polymeric piezoelectric body contains a stabilizer having a weight-average molecular weight of from 200 to 60,000 and having at least one functional group selected from the group consisting of a carbodiimide group, an epoxy group, and an isocyanate group, and wherein the stabilizer is contained in an amount of from 0.01 parts by mass to 10 parts by mass with respect to 100 parts by mass of the helical chiral polymer.
<15> The layered body according to <14>, wherein the stabilizer has, in a molecule, one functional group selected from the group consisting of a carbodiimide group, an epoxy group, and an isocyanate group.
<16> The layered body according to any one of <1> to <15>, wherein the polymer (B) is a polymer of a compound

having a (meth)acryloyl group.
<17> The layered body according to any one of <1> to <16>, wherein the polymer (B) is an active energy ray-cured resin that has been cured by active energy ray irradiation.
<18> The layered body according to any one of <1> to <17>, wherein the polymer (B) is an ultraviolet ray-cured resin that has been cured by ultraviolet ray irradiation.
<19> The layered body according to any one of <1> to <18>, wherein a ratio of an acrylic terminal of a polymer contained in the crystalline polymeric piezoelectric body is from $2.0\times10^{-5}$ to $10.0\times10^{-5}$, wherein the ratio of the acrylic terminal of the polymer is determined by the following Formula (X) based on a $^1$H-NMR spectrum measured with respect to a solution obtained by dissolving 20 mg of the crystalline polymeric piezoelectric body in 0.6 mL of deuterated chloroform:

Formula (X) Ratio of acrylic terminal of the polymer = Integral value of peak derived from acrylic terminal of the polymer / Integral value of peak derived from methines in main chain of the polymer.

ADVANTAGEOUS EFFECTS OF INVENTION

According to the invention, a layered body is provided in which scratch resistance and antistatic properties are improved while the piezoelectricity is maintained at high level and the transparency is also maintained at high level to some extent.

BRIEF DESCRIPTION OF DRAWINGS

Fig. 1 is a conceptual diagram showing a direction of cutting a specimen in tear strength measurement in Examples.

DESCRIPTION OF EMBODIMENTS

In this specification, a numerical range represented by using the term "to" includes the values written before and after the term "to", as a lower limit value and an upper limit value of the numerical range.
Further, in this specification, the term "principal plane" of the piezoelectric body used herein means a plane perpendicular to the thickness direction of the piezoelectric body. The same applies to the "principal plane" of the layered body.
In this specification, the "principal plane" may be simply referred to as "plane".
In this specification, the "film" is a concept that encompasses not only one generally called as "film" but also one generally called as "sheet".
The layered body of the invention comprises: a crystalline polymeric piezoelectric body having a standardized molecular orientation MORc of from 2.0 to 10.0 measured by a microwave transmission-type molecular orientation meter based on a reference thickness of 50 μm; and a surface layer which is disposed so that at least a part of the surface layer contacts the crystalline polymeric piezoelectric body, which has a surface resistivity of from $1\times10^6$ Ω/sq to $1\times10^{12}$ Ω/sq, and which contains an electroconductive material (A) and a polymer (B).
According to the layered body of the invention, scratch resistance and antistatic properties are improved while the piezoelectricity is maintained at high level and the transparency is also maintained at high level to some extent.
More particularly, in the layered body of the invention, the surface of the piezoelectric body is protected by a surface layer containing a polymer (B) and thus the scratch resistance is improved as compared to the piezoelectric body alone.
Further, in the layered body of the invention, the surface layer further includes an electroconductive material (A) and the surface resistivity of the surface layer is $1\times10^{12}$ Ω/sq or less, so that the antistatic properties are improved compared to the piezoelectric body alone.
Incidentally, the surface layer is different from an electrode (for example, an ITO electrode) which may be formed on the surface of the piezoelectric body in terms of the fact that the surface resistivity is $1\times10^6$ Ω/sq or more.
Further, in the layered body of the invention, despite the fact that the surface layer is layered on the piezoelectric body, the piezoelectricity of the piezoelectric body is maintained in the layered body at high level. The reason is considered to be that the surface layer includes the electroconductive material (A), as a result of which a conductive path is formed in the thickness direction of the surface layer.
In a preferred embodiment of the layered body of the invention, the electroconductive material (A) forms an

aggregated and dispersed three-dimensional network structure in the surface layer, whereby a conductive path is formed in the thickness direction of the surface layer. The embodiment is considered to be easily realized in a case in which the electroconductive material (A) is an electroconductive polymer.

Further, in the layered body of the invention, in spite of layering the surface layer on the piezoelectric body, the transparency of the piezoelectric body is maintained in the layered body at high level to some extent.

The reason is considered to be that a surface layer containing the electroconductive material (A) is layered on the piezoelectric body, thereby reducing the number of particles of the electroconductive material (A) per unit area when observed from a normal line direction relative to the principal plane as compared to the case of allowing the piezoelectric body to contain the electroconductive material (A). More particularly, in the case of layering the surface layer containing the electroconductive material (A) on the piezoelectric body, the particles of the electroconductive material (A) are present (distributed) mainly in a surface portion (i.e., the surface layer) of the layered body. In the case of allowing the piezoelectric body to contain the electroconductive material (A), the particles of the electroconductive material (A) are present (distributed) over the whole of the piezoelectric body in the thickness direction. Thus, under the premise that equivalent antistatic properties are obtained, in the case of layering the surface layer containing the electroconductive material (A) on the piezoelectric body, the less number of particles of the electroconductive material (A) per unit area is required, compared to the case of allowing the piezoelectric body to contain the electroconductive material (A). Accordingly, it is assumed that a decrease in transparency due to addition of the electroconductive material (A) can be suppressed. This tendency is significant in a case in which a thickness (d1) of the piezoelectric body and a total thickness (d2) of the surface layer satisfy a relationship of d1 > d2. In a case in which d1 is twice or more of d2 (preferably four times or more, more preferably six times or more), the tendency is particularly significant. Here, in a case in which the surface layer is present on both planes of the piezoelectric body, the total thickness (d2) of the surface layer indicates a total thickness of the surface layers on both planes. In a case in which the surface layer is present on only one plane of the piezoelectric body, the total thickness indicates a thickness of the surface layer on one plane.

Another reason why the transparency of the piezoelectric body is maintained at high level to some extent in the layered body of the invention is considered to be that the surface layer containing the electroconductive material (A) is layered on the piezoelectric body, as a result of which bleeding out of the electroconductive material (A) from the piezoelectric body is suppressed, compared to the case of allowing the piezoelectric body to contain the electroconductive material (A). In this regard, the electroconductive material (A) may be contained not only in the surface layer but also in the piezoelectric body in an amount that causes no bleeding out.

The surface layer in the invention has a function that protects the surface of the piezoelectric body (i.e., a function as a hard-coat layer) and a function as an antistatic layer. If necessary, the surface layer in the invention may further have other functions.

In an embodiment of the layered body of the invention, it is preferable that the electroconductive material (A) is an electroconductive polymer, and the polymer (B) is a polymer other than an electroconductive polymer. In this embodiment, it is easy to maintain the piezoelectricity of the piezoelectric body at high level. The reason is considered to be that the electroconductive polymer forms an aggregated and dispersed three-dimensional network structure in the surface layer whereby a conductive path is formed in the thickness direction of the surface layer.

The electroconductive polymer is preferably at least one polymer selected from the group consisting of polythiophene, a polythiophene derivative, polypyrrole, a polypyrrole derivative, polyaniline, and a polyaniline derivative from the viewpoint of easiness of maintaining the piezoelectricity of the piezoelectric body at high level.

Specific examples of the electroconductive material (A) and the polymer (B) will be described below.

As described above, the transparency of the layered body of the invention is maintained at high level to some extent.

For example, the internal haze of the layered body of the invention with respect to visible light (hereinafter, simply referred to as "internal haze") is decreased to some extent.

The internal haze of the layered body is preferably 50% or less, preferably 40% or less, more preferably 20% or less, still more preferably 13% or less, and still more preferably 5% or less from the viewpoint of transparency. Further, the internal haze of the layered body is preferably 2.0% or less and particularly preferably 1.0% or less from the viewpoint of improving the tear strength of the layered body.

Further, the lower the internal haze, the better the layered body is. From the viewpoint of the balance with the piezoelectric constant, the internal haze is preferably from 0.0% to 40%, more preferably from 0.01% to 20%, still more preferably from 0.01% to 13%, still more preferably from 0.01% to 5%, still more preferably from 0.01% to 2.0%, and particularly preferably from 0.01% to 1.0%.

The term "internal haze" used herein means a haze from which a haze caused by the shape of an external surface is excluded.

The "internal haze" is a value in a case in which the piezoelectric body is measured at 25°C with a haze meter (e.g., TC-H III DPK, manufactured by Tokyo Denshoku Co., Ltd.) in accordance with JIS-K7136 (2000).

An example of the method of measuring the internal haze will be described in the following Examples.

The total haze of the layered body of the invention with respect to visible light is also reduced, compared to the case of the piezoelectric body alone.

This reason is considered to be that the surface layer is provided on the piezoelectric body, whereby the surface is leveled. The total haze reduction effect is particularly significant in the case of forming a surface layer by a wet coating method.

Here, the term "total haze" means a haze in which a haze caused by the shape of an external surface is included.

As described above, in the layered body of the invention, piezoelectricity is maintained at high level.

For example, in the layered body of the invention, a piezoelectric constant $d_{14}$ measured by a stress-electric charge method at 25°C (hereinafter, simply referred to as "piezoelectric constant $d_{14}$") is maintained at high level.

The piezoelectric constant $d_{14}$ of the layered body is preferably 1 pC/N or more, more preferably 3 pC/N or more, and still more preferably 4 pC/N or more from the viewpoint of piezoelectricity. Further, the piezoelectric constant $d_{14}$ of the layered body is preferably 70% or more, more preferably 80% or more, and still more preferably 90% or more of the piezoelectric constant $d_{14}$ of the piezoelectric body alone.

Although there is no particular limitation on the upper limit of the piezoelectric constant $d_{14}$ of the layered body, it is preferably 50 pC/N or less, and more preferably 30 pC/N or less, from the viewpoint of transparency.

An example of the method of measuring the piezoelectric constant $d_{14}$ of the layered body will be described in the following Examples.

In a preferred embodiment, the internal haze of the layered body of the invention with respect to visible light is 50% or less, and the piezoelectric constant $d_{14}$ measured by a stress-electric charge method at 25°C is 1 pC/N or more. In the embodiment, a more preferable range of the internal haze and a more preferable range of the piezoelectric constant $d_{14}$ are described above.

[Surface Layer]

The layered body of the invention has a surface layer containing an electroconductive material (A) and a polymer (B).

The "surface layer" in the invention means a layer which exists on a surface of the piezoelectric body and in which at least a part thereof contacts the piezoelectric body. Therefore, another member may be placed on the surface layer, and the surface layer is not necessarily the outermost layer of a final formed product.

Here, another member to be placed on the surface layer of the layered body is, for example, an electrode. The electrode may be an electrode layer which covers the whole of the surface layer, or an electrode pattern formed to cover only a part of the surface layer.

Further, a multilayer film layering a plurality of layers may be formed on the piezoelectric body in the invention. In this case, the surface layer means a layer disposed so that at least a part thereof contacts the piezoelectric body.

In the layered body of the invention, the surface layer may be present on only one plane of the piezoelectric body or on both planes of the piezoelectric body. In a case in which surface layers are present on both planes of the piezoelectric body, a material of the surface layer on one plane and a material of the surface layer on the other plane may be the same or different.

The surface layer is formed, whereby a defect such as a die line or a dent on the surface of the piezoelectric body is filled, and there is an effect that appearance is improved.

In this case, the smaller the difference in a refractive index between the piezoelectric body and the surface layer, the less the reflection on the interface between the piezoelectric body and the surface layer is, and the appearance is further improved.

The surface resistivity of the surface layer is from $1\times10^6$ Ω/sq to $1\times10^{12}$ Ω/sq.

The surface resistivity of the surface layer is $1\times10^{12}$ Ω/sq or less, so that the antistatic properties of the layered body are improved.

The surface resistivity of the surface layer is $1\times10^6$ Ω/sq or more, so that the amount of the electroconductive material (A) to be added to the surface layer can be decreased. Accordingly, a decrease in scratch resistance and a decrease in productivity can be suppressed, and further the production cost can be reduced.

<Electroconductive Material (A)>

The surface layer contains an electroconductive material (A).

Thus, the antistatic properties of the layered body are improved as described above.

Further, the surface layer of the layered body contains the electroconductive material (A) (preferably an electroconductive polymer), so that the moist heat resistance of the layered body tends to improve compared to the moist heat resistance of the piezoelectric body alone.

The surface layer may contain only one kind or two or more kinds of the electroconductive materials (A).

There is no particular limitation on the electroconductive material (A), and examples thereof include an organic electroconductive material and an inorganic electroconductive material.

Examples of the organic electroconductive material include various cationic compounds having a cationic group such as a quaternary ammonium salt group, a pyridinium salt group, an imidazolium salt group or a primary to tertiary amino group; an anionic compound having an anionic group such as a sulfonic acid salt group, a sulfuric acid ester salt group, a phosphoric acid ester salt group or a phosphonic acid salt group; an amphoteric compound such as an amino acid compound or an amino sulfuric acid ester compound; a nonionic compound such as an aminoalcohol compound, a glycerin compound or a polyethylene glycol compound; an organometallic compound such as an alkoxide of at least one of tin or titanium; and a metal chelate compound such as an acetylacetonato salt of the organometallic compound.

The organic electroconductive material is, for example, an electroconductive polymer.

Examples of the electroconductive polymer include polymers in which the above listed specific examples of the organic electroconductive material are made to have a high-molecular weight; polyacethylene and its derivative; polyacene and its derivative; polyazulene and its derivative; polypyrrole and its derivative; polythiophene and its derivative; polyisothianaphthene and its derivative; polyaniline and its derivative; polythienylenevinylene and its derivative; poly(phenylenevinylene) and its derivative; multiple-chain type conjugated polymers having a plurality of conjugated polymer chains in the molecule; and a conducting composite which is a polymer obtained by graft-copolymerizing or block-copolymerizing the above conjugated polymer chain onto a saturated polymer.

From the viewpoint of more effectively exerting the effect of the invention, the electroconductive polymer is preferably at least one polymer selected from the group consisting of polythiophene, a polythiophene derivative, polypyrrole, a polypyrrole derivative, polyaniline, and a polyaniline derivative, and more preferably at least one polymer selected from the group consisting of polythiophene and a polythiophene derivative.

More particularly, even if each of polythiophene, polypyrrole, and polyaniline (which are examples of the electroconductive polymer) is unsubstituted, sufficient electrical conductivity and compatibility with the component of the surface layer can be obtained. In order to improve the electrical conductivity and compatibility with the component of the surface layer, it is preferable that each of polythiophene, polypyrrole, and polyaniline is converted to a derivative having a functional group such as an alkyl group, a carboxy group, a sulfonic group, an alkoxy group, a hydroxy group or a cyano group.

Specific examples of the electroconductive polymer include polypyrrole, poly(N-methylpyrrole), poly(3-methylpyrrole), poly(3-ethylpyrrole), poly(3-n-propylpyrrole), poly(3-butylpyrrole), poly(3-octylpyrrole), poly(3-decylpyrrole), poly(3-dodecylpyrrole), poly(3,4-dimethylpyrrole), poly(3,4-dibutylpyrrole), poly(3-carboxypyrrole), poly(3-methyl-4-carboxypyrrole), poly(3-methyl-4-carboxyethylpyrrole), poly(3-methyl-4-carboxybutylpyrrole), poly(3-hydroxypyrrole), poly(3-methoxy pyrrole), poly(3-ethoxypyrrole), poly(3-butoxypyrrole), poly(3-hexyloxypyrrole), poly(3-methyl-4-hexyloxypyrrole), poly(3-ethyl-4-hexyloxypyrrole); polythiophene, poly(3-methylthiophene), poly(3-ethylthiophene), poly(3-propylthiophene), poly(3-butylthiophene), poly(3-hexylthiophene), poly(3-heptylthiophene), poly(3-octylthiophene), poly(3-decylthiophene), poly(3-dodecylthiophene), poly(3-octadecylthiophene), poly(3-bromothiophene), poly(3-chlorothiophene), poly(3-iodothiophene), poly(3-cyanothiophene), poly(3-phenylthiophene), poly(3,4-dimethylthiophene), poly(3,4-dibutylthiophene), poly(3-hydroxy thiophene), poly(3-methoxythiophene), poly(3-ethoxythiophene), poly(3-butoxythiophene), poly(3-hexyloxythiophene), poly(3-heptyloxythiophene), poly(3-octyloxythiophene), poly(3-decyloxythiophene), poly(3-dodecyloxythiophene), poly(3-octadecyloxythiophene), poly(3,4-dihydroxythiophene), poly(3,4-dimethoxythiophene), poly(3,4-diethoxythiophene), poly(3,4-dipropoxythiophene), poly(3,4-dibutoxythiophene), poly(3,4-dihexyloxythiophene), poly(3,4-diheptyloxythiophene), poly(3,4-dioctyloxythiophene), poly(3,4-didecyloxythiophene), poly(3,4-didodecyloxythiophene), poly(3,4-ethylenedioxythiophene), poly(3,4-propylenedioxythiophene), poly(3,4-butenedioxythiophene), poly(3-methyl-4-methoxythiophene), poly(3-methyl-4-ethoxythiophene), poly(3-carboxythiophene), poly(3-methyl-4-carboxythiophene), poly(3-methyl-4-carboxyethylthiophene), poly(3-methyl-4-carboxybutylthiophene); polyaniline, poly(2-methylaniline), poly(3-isobutylaniline), poly(2-aniline sulfonic acid), and poly(3-aniline sulfonic acid).

Among the above specific examples, (co)polymers consisting of one or two or more selected from polypyrrole, polythiophene, poly(N-methylpyrrole), poly(3-methylthiophene), poly(3-methoxythiophene), and poly(3,4-ethylenedioxythiophene) are suitably used from the viewpoints of resistance value and the reactivity.

Among them, polypyrrole and poly(3,4-ethylenedioxythiophene) are more preferred in terms of the fact that they have a high conductivity, and the heat resistance and moist heat resistance are improved.

From the viewpoint of improving the electrical conductivity and heat resistance, a dopant may be added to the electroconductive polymer.

The dopant is, for example, a polymer having an anion group (hereinafter referred to as "polyanion").

Examples of the polyanion include substituted or unsubstituted polyalkylene, substituted or unsubstituted polyalkenylene, substituted or unsubstituted polyimide, substituted or unsubstituted polyamide, substituted or unsubstituted polyester, or their copolymers including a structural unit having an anion group and a structural unit having no anion group.

The inorganic electroconductive material is, for example, an electroconductive filler.

Examples of the electroconductive filler include tin oxide; indium tin oxide; phosphorus-doped tin oxide; antimony-doped tin oxide; indium oxide; zinc oxide; indium zinc oxide; antimony oxide; at least one selected from Al, Si, Ti, V, Cr, Fe, Co, Ni, Cu, Zn, In, Sn, W, Ag, Au, Pd, Pt, Sb, Ta, or Zr, or alloys of these metals; carbon black; vapor-phase growth carbon fiber; and carbon nanotube.

From the viewpoint of more effectively exerting the effect of the invention, the electroconductive material (A) is preferably an organic electroconductive material, more preferably an electroconductive polymer, still more preferably at least one kind of polymer selected from the group consisting of polythiophene, a polythiophene derivative, polypyrrole, a polypyrrole derivative, polyaniline, and a polyaniline derivative, and particularly preferably at least one kind of polymer selected from the group consisting of polythiophene and a polythiophene derivative.

In a preferred embodiment, the content of the electroconductive material (A) in the surface layer (in a case in which two or more kinds are present, the total content) is from 0.01% by mass to 30% by mass with respect to the total amount of the surface layer.

When the content of the electroconductive material (A) is 0.01% by mass or more, the antistatic properties are further improved.

When the content of the electroconductive material (A) is 30% by mass or less, it becomes easy to ensure the amount of the polymer (B), thereby easily improving the scratch resistance.

The content of the electroconductive material (A) is preferably from 0.1% by mass to 10% by mass and more preferably from 0.5% by mass to 5% by mass.

<Polymer (B)>

The surface layer contains a polymer (B).

The surface layer may contain only one kind or two or more kinds of the polymers (B).

There is no particular limitation on the polymer (B). In the case of using the electroconductive polymer as the electroconductive material (A), a polymer other than an electroconductive polymer is used as the polymer (B).

It is preferable to include a polymer having a carbonyl group (-C(=O)-) as the polymer (B). The polymer has a carbonyl group, so that the adherence between the polymer and the piezoelectric body is improved.

The method of forming a surface layer including a polymer having a carbonyl group is, for example, a method of polymerizing a composition which contains a compound having a carbonyl group and a functional compound having a reactive group. In this case, the compound having a carbonyl group and the functional compound may be the same or may not be the same.

In a case in which the compound having a carbonyl group and the functional compound are the same, a reactive group of the functional compound may include a carbonyl group, or a structure other than the reactive group of the functional compound may include a carbonyl group. In a case in which the compound having a carbonyl group and the functional compound are not the same, the compound having a carbonyl group has one or more reactive groups which can react with the functional compound.

A polymerization reaction may be a reaction between reactive groups of one kind, or a reaction between reactive groups of different two or more kinds. When the polymerization reaction is a reaction between reactive groups of different two or more kinds, a compound including different two or more kinds of reactive groups in the same molecule may be used, or a mixture of a functional compound including two or more of the same reactive groups and a functional compound including two or more other reactive groups, which are reactive with the above-described reactive groups, may be used.

Examples of a reactive group for a reaction between the reactive groups of one kind (hereinafter simply referred to as "homogeneous reactive group") include an acryloyl group, a methacryloyl group, a vinyl group, an allyl group, an isocyanate group, and an epoxy group.

Each of the acryloyl group, the methacryloyl group, and the isocyanate group has a carbonyl group in the structure thereof. In a case in which a compound having a reactive group (i.e., a vinyl group, an allyl group or an epoxy group) is used, a compound having a carbonyl group in a structure other than the reactive group may be used as the compound.

From the viewpoint of formation of a three-dimensionally cross-linked structure in the polymer, a bi- or higher functional compound having such homogeneous reactive groups exists at least partly in a composition, so that a three-dimensionally cross-linked structure can be formed.

Examples of a combination of reactive groups for the reaction of two or more kinds of reactive groups (hereinafter simply referred to as "heterogeneous reactive group") include an epoxy group and a carboxy group, an epoxy group and an amino group, an epoxy group and a hydroxy group, an epoxy group and an acid anhydride group, an epoxy group and a hydrazide group, an epoxy group and a thiol group, an epoxy group and an imidazolyl group, an epoxy group and an isocyanate group, an isocyanate group and a carboxy group, an isocyanate group and an amino group, an isocyanate group and a hydroxy group, a carbodiimide group and an amino group, a carbodiimide group and a carboxy group, an oxazolino group and a carboxy group, and a hydrazide group and a carboxy group.

From the viewpoint of formation of a three-dimensionally cross-linked structure in the polymer, a tri- or more

functional compound having either or both of such heterogeneous reactive groups exists at least partly in a composition, so that a three-dimensionally cross-linked structure can be formed.

Among them, a carboxy group, an acid anhydride group, a hydrazide group, and an isocyanate group have a carbonyl group in the structure thereof. In a case in which a compound having a reactive group other than the above groups is used, a compound having a carbonyl group in a structure other than the reactive group may be used as the compound.

Examples of a functional compound having an epoxy group and a carbonyl group in the same molecule include an epoxy acrylate.

Examples of a functional compound having a hydroxy group and a carbonyl group in the same molecule include polyester polyol, polyurethane polyol, acrylic polyol, polycarbonate polyol, and partially carboxylated methylcellulose.

Examples of a functional compound having an amino group and a carbonyl group in the same molecule include an amine-terminated polyamide, an amine-terminated polyimide, and an amine-terminated polyurethane.

Among the above examples, the polymer (B) is more preferably a polymer of a compound having a (meth)acryloyl group, and particularly preferably a polymer having a three-dimensionally cross-linked structure which is a polymer of a compound having a (meth)acryloyl group, from the viewpoints of improving the adherence between the piezoelectric body and the surface layer and improving the scratch resistance of the layered body.

Here, the term "(meth)acryloyl group" means an acryloyl group or a methacryloyl group.

From the viewpoint of improving the scratch resistance, it is preferable that the polymer (B) is a polymer having a three-dimensionally cross-linked structure.

Here, a method of confirming whether or not a polymer contained in a surface layer is a polymer having a three-dimensionally cross-linked structure is, for example, a method of measuring a gel fraction.

Specifically, the gel fraction can be determined based on an insoluble matter obtained after immersing a surface layer in a solvent for 24 hours. In the measurement of the gel fraction, in a case in which the gel fraction is at a certain level or more in each of the case of using a hydrophilic solvent (such as water) and the case of using a lipophilic solvent (such as toluene), it may be presumed that the polymer has a three-dimensionally cross-linked structure.

From the viewpoints of improving the adherence between the piezoelectric body and the surface layer and improving the scratch resistance of the layered body, the polymer (B) is preferably a polymer having a three-dimensionally cross-linked structure which is a polymer of a compound having a (meth)acryloyl group.

Hereinafter, the compound having a (meth)acryloyl group is occasionally referred to as "(meth)acrylic compound". Here, the term "(meth)acrylic compound" means an acrylic compound or a methacrylic compound.

The method of producing a polymer having a three-dimensionally cross-linked structure is, for example, a method of polymerizing a composition which contains a functional compound having two or more reactive groups. The method may also be a method of using isocyanate, polyol, organic peroxide or the like as a crosslinking agent. Incidentally, these methods may be used in combination.

Examples of a bi- or higher functional compound include a (meth)acrylic compound having two or more (meth)acryloyl groups in a molecule.

Examples of a tri- or higher functional compound include an epoxy compound having three or more epoxy groups in a molecule and an isocyanate compound having three or more isocyanate groups in a molecule.

From the viewpoint of improving the scratch resistance of the layered body and improving the production efficiency, the polymer (B) is preferably an active energy ray-cured resin that has been cured by active energy ray (ultraviolet ray, electron beam, radiation, etc.) irradiation.

Among active energy ray-cured resins, an ultraviolet ray-cured resin that has been cured by ultraviolet ray irradiation is particularly preferred.

The active energy ray-cured resin (preferably, a ultraviolet ray-cured resin) is more preferably an active energy ray-cured resin which is a polymer of a compound having a (meth) acryloyl group, and particularly preferably an active energy ray-cured resin which is a polymer of a compound having a (meth)acryloyl group and which is a polymer having a three-dimensionally cross-linked structure.

In a preferred embodiment, the content of the polymer (B) in the surface layer (in a case in which two or more kinds are present, the total content) is from 70% by mass to 99.9% by mass with respect to the total amount of the surface layer.

When the content of the polymer (B) is 99.9% by mass or less, it becomes easy to ensure the amount of the electroconductive material (A) in the surface layer, thereby easily improving antistatic properties.

When the content of the polymer (B) is 70% by mass or more, the scratch resistance is easily improved.

The content of the polymer (B) is more preferably from 90% by mass to 99.9% by mass and still more preferably from 95% by mass to 99.5% by mass.

The surface layer may contain components other than the electroconductive material (A) and the polymer (B), if necessary.

Examples of other components include various organic substances and various inorganic substances, such

as a refractive index adjuster, an ultraviolet absorber, a leveling agent, an anti-blocking agent, and a hue adjuster.
In this regard, from the viewpoint of more effectively exerting the effect of the invention, the total content of the electroconductive material (A) and the polymer (B) in the surface layer is preferably 80% by mass or more and more preferably 90% by mass or more with respect to the total amount of the surface layer.
The thickness of the surface layer is not particularly limited and is preferably from 0.01 μm to 10 μm.
When the thickness of the surface layer is 0.01 μm or more, the scratch resistance of the layered body is further improved.
When the thickness of the surface layer is 10 μm or less, the handling property of the layered body (for example, workability when rewinding the layered body) is further improved.
In a case in which surface layers are present on both planes of the piezoelectric body, the term "thickness of the surface layer" used herein means a thickness of the surface layer on one plane.
The upper limit of the thickness of the surface layer is more preferably 6 μm.
The lower limit of the thickness of the surface layer is more preferably 0.2 μm, still more preferably 0.3 μm, and particularly preferably 1 μm.
The thickness of the surface layer is determined using a digital length measuring machine (DIGIMICRO STAND MS-11C, manufactured by Nikon Corporation) according to the following formula.

$$\text{Formula} \qquad d = dt - dp$$

d: thickness of the surface layer (in a case in which surface layers are present on both planes, the total thickness of the surface layers on both planes)
dt: ten point average thickness of the layered body
dp: ten point average thickness of the piezoelectric body before formation of the surface layer or after removal of the surface layer

As a method of forming a surface layer, a publicly known method can be used appropriately, and there is, for example, a wet coating method.
Examples of the method of forming a surface layer by the wet coating method include:

(method 1) a method including applying a coating liquid which contains an electroconductive material (A), a polymer (B), and a solvent onto at least one of planes of a piezoelectric body, and performing a dry process, if necessary, to form a surface layer; and
(method 2) a method including applying a coating liquid which contains an electroconductive material (A), a precursor of a polymer (B) (monomer or oligomer), and a solvent onto at least one of planes of a piezoelectric body (and subsequently performing a dry process, if necessary), curing a coating film of the coating liquid by polymerizing the precursor to form a polymer (B), and thus forming a surface layer.

In the method 2, the precursor can be polymerized by heat or active energy ray (ultraviolet ray, electron beam, radiation, etc.).
For example, in a case in which the polymer (B) is an active energy ray-cured resin, the method 2 can be used.
In a case in which the piezoelectric body described below is obtained by stretching a piezoelectric body original plate (original plate before stretching) and a surface layer is formed by the method 2, the piezoelectric body original plate may be stretched after applying the coating liquid to the piezoelectric body original plate and then the coating film of the coating liquid may be cured, or the piezoelectric body original plate may be stretched, the coating liquid may be applied to the stretched piezoelectric body original plate, and then the coating film of the coating liquid may be cured.
A surface of the piezoelectric body may be subjected to a corona treatment, an Itro treatment, an ozone treatment, a plasma treatment, or the like before formation of the surface layer. Thus, the adherence between the surface of the piezoelectric body and the surface layer can be improved, and the coating property of the coating liquid onto the surface of the piezoelectric body can be improved.

[Crystalline Polymeric Piezoelectric Body]

The layered body of the invention has a crystalline polymeric piezoelectric body (piezoelectric body).
Polymers are oriented in the crystalline polymeric piezoelectric body (piezoelectric body). The piezoelectricity of the piezoelectric body is generated by the orientation (molecular orientation).
An indicator of the orientation is a "molecular orientation ratio MOR". The molecular orientation ratio (MOR) is

a value indicating the degree of molecular orientation, and measured by the following microwave measurement method.

Namely, a sample (piezoelectric body) is placed in a microwave resonance waveguide of a well known microwave molecular orientation ratio measuring apparatus (also referred to as a "microwave transmission-type molecular orientation meter") such that the sample plane (a principal plane of the piezoelectric body; for example, a film plane in a case in which the piezoelectric body is a film-shaped piezoelectric body) is arranged perpendicular to the travelling direction of the microwaves. Then, while the sample is continuously irradiated with microwaves of which oscillating direction is biased unidirectionally, the sample is rotated in a plane perpendicular to the travelling direction of the microwaves from 0 to 360°, and the intensity of the microwaves passed through the sample is measured to determine the molecular orientation ratio MOR.

Here, a standardized molecular orientation MORc means a MOR value to be measured at the reference thickness tc of 50 μm and is determined by the following formula.

$$MORc = (tc/t) \times (MOR-1) + 1$$

(tc: reference thickness for correction; t: sample thickness)

The standardized molecular orientation MORc can be measured by a publicly known molecular orientation meter, e.g. a microwave-type molecular orientation analyzer MOA-2012A or MOA-6000, manufactured by Oji Scientific Instruments, at a resonance frequency in the vicinity of 4 GHz or 12 GHz.

The standardized molecular orientation MORc of the piezoelectric body in the invention is from 2.0 to 10.0.

When the standardized molecular orientation MORc is 2.0 or more, the piezoelectricity of the piezoelectric body is improved by the orientation of polymers.

When the standardized molecular orientation MORc is 10.0 or less, a decrease in longitudinal tear strength of the piezoelectric body (a decrease in tear strength in a specific direction; the same shall apply hereinafter) is suppressed.

The standardized molecular orientation MORc is preferably from 2.5 to 8.0 and more preferably from 3.0 to 4.5.

Further, the standardized molecular orientation MORc can be regulated by crystallization conditions (for example, heating temperature and heating time), and stretching conditions (for example, stretching temperature and stretching speed) during production of the piezoelectric body.

In this regard, the standardized molecular orientation MORc can be converted to birefringence Δn, which equals to retardation divided by the thickness of the piezoelectric body.

Specifically, the retardation can be measured by an RETS 100, manufactured by Otsuka Electronics Co., Ltd. Further, MORc and Δn are approximately in a linearly proportional relationship, and when Δn is 0, MORc is 1.

The crystallinity of the piezoelectric body determined by a DSC method is preferably from 20% to 80% and more preferably from 30% to 70%.

When the crystallinity is 20% or more, the piezoelectricity of the piezoelectric body is further improved.

When the crystallinity is 80% or less, a decrease in longitudinal tear strength of the piezoelectric body and a decrease in transparency of the piezoelectric body are suppressed.

The product of the crystallinity and the MORc of the piezoelectric body is preferably from 25 to 700, more preferably from 40 to 700, and still more preferably from 40 to 250.

When the product of the crystallinity and the MORc is 25 or more, the piezoelectricity of the piezoelectric body is further improved.

When the product of the crystallinity and the MORc is 700 or less, a decrease in longitudinal tear strength of the piezoelectric body and a decrease in transparency of the piezoelectric body are suppressed.

The product of the crystallinity and the MORc is more preferably from 50 to 200 and still more preferably from 100 to 200.

The product of the crystallinity and the MORc can be regulated by, for example, regulating conditions for crystallization and stretching in producing the piezoelectric body.

The piezoelectric constant $d_{14}$ of the piezoelectric body measured at 25°C by a stress-electric charge method is preferably 1 pC/N or more, more preferably 3 pC/N or more, and still more preferably 4 pC/N or more from the viewpoint of piezoelectricity.

The upper limit of the piezoelectric constant $d_{14}$ of the piezoelectric body is not particularly limited, and is preferably 50 pC/N or less and more preferably 30 pC/N or less from the viewpoint of transparency.

The piezoelectric constant $d_{14}$ of the piezoelectric body is measured by the same method as that of the piezoelectric constant $d_{14}$ of the layered body.

The internal haze of the piezoelectric body with respect to visible light is preferably 50% or less, preferably 40% or less, more preferably 20% or less, still more preferably 13% or less, and still more preferably 5% or less. The internal haze of the piezoelectric body is preferably 2.0% or less, and particularly preferably 1.0% or less from the

viewpoint of suppressing a decrease in longitudinal tear strength of the piezoelectric body.

Further, the lower the internal haze of the piezoelectric body, the better the piezoelectric body is. From the viewpoint of a balance with the piezoelectric constant, it is preferably from 0.0% to 40%, more preferably from 0.01% to 20%, still more preferably from 0.01 % to 13%, still more preferably from 0.01 % to 5%, still more preferably from 0.01 % to 2.0%, and particularly preferably from 0.01 % to 1.0%. The internal haze of the piezoelectric body is measured by the same method as that of the internal haze of the layered body.

In a preferred embodiment, the internal haze of the piezoelectric body with respect to visible light is 50% or less, and the piezoelectric constant $d_{14}$ measured by a stress-electric charge method at 25°C is 1 pC/N or more. In the piezoelectric body of the embodiment, a more preferable range of the internal haze and a more preferable range of the piezoelectric constant $d_{14}$ are described above.

<Helical Chiral Polymer Having Optical Activity (Optically Active Polymer)>

It is preferable that the piezoelectric body contains a helical chiral polymer having optical activity as the polymer.

A helical chiral polymer having optical activity refers to a polymer which has a helical molecular structure and molecular optical activity.

The "helical chiral polymer having optical activity" is herein also referred to as "optically active polymer".

Examples of the optically active polymer include polypeptide, cellulose, a cellulose derivative, a polylactic acid-based polymer, poly(propylene oxide), and poly(β-hydroxybutyric acid). Examples of the polypeptide include poly(γ-benzyl glutarate), and poly(γ-methyl glutarate). Examples of the cellulose derivative include cellulose acetate and cyanoethyl cellulose.

From the viewpoint of improvement of the piezoelectricity of the piezoelectric body, the optical purity of the optically active polymer is preferably 95.00% ee or higher, more preferably 99.00% ee or higher, still more preferably 99.99% ee or higher, and desirably 100.00% ee. It is presumed that packing property of a polymer crystal exhibiting piezoelectricity is improved by selecting the optical purity of the optically active polymer in the above range, and as a result, the piezoelectricity is increased.

Here, the optical purity of the optically active polymer is a value calculated according to the following formula.

$$\text{Optical purity (\%ee)} = 100 \times |\text{L-form amount} - \text{D-form amount}| / (\text{L-form amount} + \text{D-form amount})$$

Namely, a value of "the difference (absolute value) between L-form amount [% by mass] of the optically active polymer and D-form amount [% by mass] of the optically active polymer" divided by "the total of L-form amount [% by mass] of the optically active polymer and D-form amount [% by mass] of the optically active polymer" and multiplied by "100" is defined as optical purity.

Incidentally, for the L-form amount [% by mass] of the optically active polymer and the D-form amount [% by mass] of the optically active polymer, values obtained by a method using high performance liquid chromatography (HPLC) are used. Specific details of measurement will be described below.

Among the above optically active polymers, the polymer having a main chain including a repeating unit represented by the following Formula (1) is preferred from the viewpoint of enhancement of the optical purity and improvement of the piezoelectricity.

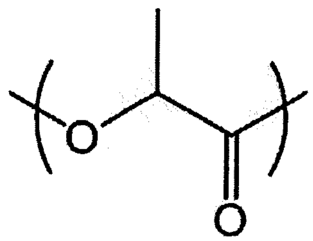

(1)

The compound having a main chain including a repeating unit represented by the above Formula (1) is, for example, a polylactic acid-based polymer. Among others, polylactic acid is preferred, and a homopolymer of L-lactic acid (PLLA) or a homopolymer of D-lactic acid (PDLA) is most preferable.

The polylactic acid-based polymer means "polylactic acid", "a copolymer of L-lactic acid or D-lactic acid with a copolymerizable multi-functional compound", or a mixture of the two. The "polylactic acid" is a polymer in which lactic acid is polymerized through ester bonds to form a long chain, and it is known that polylactic acid can be produced by a

lactide method via lactide, a direct polymerization method, by which lactic acid is heated in a solvent under a reduced pressure for polymerizing while removing water, or the like. Examples of the "polylactic acid" include a homopolymer of L-lactic acid, a homopolymer of D-lactic acid, a block copolymer including a polymer of at least one of L-lactic acid and D-lactic acid, and a graft copolymer including a polymer of at least one of L-lactic acid and D-lactic acid.

Examples of the "copolymerizable multi-functional compound" include a hydroxycarboxylic acid such as glycolic acid, dimethylglycolic acid, 3-hydroxybutyric acid, 4-hydroxybutyric acid, 2-hydroxypropanoic acid, 3-hydroxypropanoic acid, 2-hydroxyvaleric acid, 3-hydroxyvaleric acid, 4-hydroxyvaleric acid, 5-hydroxyvaleric acid, 2-hydroxycaproic acid, 3-hydroxycaproic acid, 4-hydroxycaproic acid, 5-hydroxycaproic acid, 6-hydroxycaproic acid, 6-hydroxymethylcaproic acid, mandelic acid; a cyclic ester such as glycolide, β-methyl-δ-valerolactone, γ-valerolactone, and ε-caprolactone; a polycarboxylic acid such as oxalic acid, malonic acid, succinic acid, glutaric acid, adipic acid, pimelic acid, azelaic acid, sebacic acid, undecanedioic acid, dodecanedioic acid, and terephthalic acid, and anhydrides of these acids; a polyhydric alcohol such as ethyleneglycol, diethyleneglycol, triethyleneglycol, 1,2-propanediol, 1,3-propanediol, 1,3-butanediol, 1,4-butanediol, 2,3-butanediol, 1,5-pentanediol, 1,6-hexandiol, 1,9-nonanediol, 3-methyl-1,5-pentanediol, neopentylglycol, tetramethyleneglycol, and 1,4-hexanedimethanol; a polysaccharide such as cellulose; and an aminocarboxylic acid such as α-amino acid.

Examples of the "copolymer of L-lactic acid or D-lactic acid with a copolymerizable multi-functional compound" include a block copolymer or a graft copolymer having a polylactic acid sequence, which can form a helical crystal.

The concentration of a structure derived from a copolymer component in the optically active polymer is preferably 20 mol % or less. For example, in a case in which the optically active polymer is a polylactic acid-based polymer, with respect to the total number of moles of a structure derived from lactic acid and a structure derived from a compound copolymerizable with lactic acid (copolymer component) in the polylactic acid-based polymer, the copolymer component is preferably 20 mol % or less.

The optically active polymer (e.g., polylactic acid-based polymer) can be produced, for example, by a method of yielding the optically active polymer by direct dehydration condensation of lactic acid, as described in JP-A Nos. S59-096123 and H7-033861, or a method of yielding the optically active polymer by a ring-opening polymerization of lactide, which is a cyclic dimer of lactic acid, as described in U.S. Patent Nos. 2,668,182 and 4,057,357.

Further, in order to adjust the optical purity of the optically active polymer (e.g., polylactic acid-based polymer) obtained by any of the production methods to 95.00% ee or higher, for example, when a polylactic acid is produced by a lactide method, it is preferable to polymerize lactide, of which optical purity has been enhanced to 95.00% ee or higher by a crystallization operation.

<Weight-Average Molecular Weight of Optically Active Polymer>

The weight-average molecular weight (Mw) of the optically active polymer of the invention is preferably from 50,000 to 1,000,000.

When the weight-average molecular weight (Mw) of the optically active polymer is 50,000 or higher, the mechanical strength of a formed product from the optically active polymer becomes sufficient. The weight-average molecular weight (Mw) of the optically active polymer is preferably 100,000 or higher, and more preferably 150,000 or higher. Meanwhile, when the weight-average molecular weight (Mw) of the optically active polymer is 1,000,000 or less, molding of the optically active polymer (for example, forming into a film by extrusion molding) can be performed easily. The weight-average molecular weight (Mw) is preferably 800,000 or less, and more preferably 300,000 or less.

The molecular weight distribution (Mw/Mn) of the optically active polymer is preferably from 1.1 to 5, more preferably from 1.2 to 4 from the viewpoint of the strength of the piezoelectric body. Further, it is preferably from 1.4 to 3.

Here, the Mw and the Mw/Mn of the optically active polymer is measured using a gel permeation chromatograph (GPC). An example of the method of measuring the Mw and the Mw/Mn of the optically active polymer will be described in the following Examples.

As a polylactic acid-based polymer (i.e., an optically active polymer), a commercially available polylactic acid may be used.

Examples of the commercially available polylactic acid include PURASORB (PD, PL) manufactured by Purac Corporate, LACEA (H-100, H-400) manufactured by Mitsui Chemicals, Inc., and INGEO 4032D, 4043D, etc. manufactured by NatureWorks LLC.

When the polylactic acid-based polymer is used as the optically active polymer, in order to adjust the weight-average molecular weight (Mw) of the polylactic acid-based polymer to 50,000 or higher, it is preferable to produce the optically active polymer by a lactide method, or a direct polymerization method.

The piezoelectric body may contain only one kind or two or more kinds of the above optically active polymers.

Although there is no particular limitation on the content of the optically active polymer (in a case in which two or more kinds are present, the total content; the same shall apply hereinafter) in the piezoelectric body, 80% by mass or more with respect to the total mass of the piezoelectric body is preferred.

When the content is 80% by mass or more, the piezoelectric constant $d_{14}$ tends to grow larger.

<Stabilizer>

It is preferable that the piezoelectric body further contains a stabilizer with a weight-average molecular weight of from 200 to 60,000 which has, in a molecule, one or more kinds of functional groups selected from the group consisting of a carbodiimide group, an epoxy group, and an isocyanate group. Thus, the moist heat resistance of the piezoelectric body is further improved.
As the stabilizer, the "stabilizer (B)" described in paragraphs 0039 to 0055 of PCT International Publication No. WO 2013/054918 can be used.
Examples of a compound having a carbodiimide group in a molecule (carbodiimide compound) to be used as a stabilizer include a monocarbodiimide compound, a polycarbodiimide compound, and a cyclic carbodiimide compound.
As the monocarbodiimide compound, dicyclohexylcarbodiimide, bis-2,6-diisopropylphenyl carbodiimide or the like is preferred.
As the polycarbodiimide compound, products produced by various methods can be used. Products produced by conventional known methods of producing polycarbodiimide (e.g., U.S. Patent No. 2,941,956, Japanese Patent Publication (JP-B) No. S47-33279, J. Org. Chem. 28, 2069-2075 (1963), Chemical Review 1981, Vol. 81, No. 4, p. 619-621) can be used. Specifically, the carbodiimide compound described in Japanese Patent No. 4,084,953 can be also used.
Examples of the polycarbodiimide compound include poly(4,4'-dicyclohexylmethanecarbodiimide), poly(N,N'-di-2,6-diisopropylphenylcarbodiimide), and poly(1,3,5-triisopropylphenylene-2,4-carbodiimide).
The cyclic carbodiimide compound can be synthesized based on the method described in JP-A No. 2011-256337.
A commercial product may be used as a carbodiimide compound, and examples thereof include B2756 (trade name) manufactured by Tokyo Chemical Industry Co., Ltd., CARBODILITE LA-1 manufactured by Nisshinbo Chemical Inc., and STABAXOL P, STABAXOL P400, and STABAXOL I (all are trade names) manufactured by Rhein Chemie Rheinau GmbH.
Examples of a compound having an isocyanate group in a molecule (isocyanate compound) to be used as a stabilizer include 3-(triethoxysilyl)propyl isocyanate, 2,4-tolylene diisocyanate, 2,6-tolylene diisocyanate, m-phenylene diisocyanate, p-phenylene diisocyanate, 4,4'-diphenylmethane diisocyanate, 2,4'-diphenylmethane diisocyanate, 2,2'-diphenylmethane diisocyanate, xylylenediisocyanate, hydrogenated xylylenediisocyanate, and isophorone diisocyanate.
Examples of a compound having an epoxy group in a molecule (epoxy compound) to be used as a stabilizer include phenyl glycidyl ether, diethyleneglycol diglycidyl ether, bisphenol A-diglycidyl ether, hydrogenated bisphenol A-diglycidyl ether, a phenol novolak-type epoxy resin, a cresol novolak-type epoxy resin, and an epoxidized polybutadiene.
As described above, the weight-average molecular weight of the stabilizer is from 200 to 60,000, more preferably from 200 to 30000, and still more preferably from 300 to 18,000.
When the weight-average molecular weight of the stabilizer is within the above range, the stabilizer can move easily, and an improving effect on moist heat resistance can be attained more sufficiently.
The weight-average molecular weight of the stabilizer is particularly preferably from 200 to 900. Incidentally, the weight-average molecular weight of from 200 to 900 is almost the same as a number average molecular weight of from 200 to 900. Further, in a case in which the weight-average molecular weight is from 200 to 900, the molecular weight distribution is 1.0 in some cases. In this case, the "weight-average molecular weight of from 200 to 900" may be reworded as "molecular weight of from 200 to 900".
In a case in which the piezoelectric body contains a stabilizer, the piezoelectric body may contain one kind or two or more kinds of the stabilizers.
In a case in which the piezoelectric body contains an optically active polymer and a stabilizer, the content of the stabilizer (in a case in which two or more kinds are present, the total content; the same shall apply hereinafter) is preferably in a range of from 0.01 parts by mass to 10 parts by mass, more preferably in a range of from 0.01 parts by mass to 5 parts by mass, still more preferably in a range of from 0.1 parts by mass to 3 parts by mass, and particularly preferably in a range of from 0.5 parts by mass to 2 parts by mass with respect to 100 parts by mass of the optically active polymer.
When the content is 0.01 parts by mass or more, the moist heat resistance is further improved.
Further, when the content is 10 parts by mass or less, a decrease in transparency is further suppressed.
Examples of a preferable embodiment of a stabilizer include an embodiment in which a stabilizer (S1) which has one or more kinds of functional groups selected from the group consisting of a carbodiimide group, an epoxy group, and an isocyanate group, and which has a number average molecular weight of from 200 to 900, and a stabilizer (S2) which has in a molecule two or more functional groups of one or more kinds selected from the group consisting of a carbodiimide group, an epoxy group, and an isocyanate group and which has a weight-average molecular weight of

from 1000 to 60000 are used in combination. Incidentally, the weight-average molecular weight of the stabilizer (S1) with a number average molecular weight of from 200 to 900 is about from 200 to 900, and the number average molecular weight and the weight-average molecular weight of the stabilizer (S1) are almost the same values.

In a case in which the stabilizer (S1) and the stabilizer (S2) are used in combination, it is preferable to contain a larger amount of the stabilizer (S1) from the viewpoint of improving the transparency.

Specifically, the amount of the stabilizer (S2) is preferably in a range of from 10 parts by mass to 150 parts by mass relative to 100 parts by mass of the stabilizer (S1), from the viewpoint of coexistence of transparency and moist heat resistance, more preferably in a range of from 30 parts by mass to 100 parts by mass, and particularly preferably in a range of from 50 parts by mass to 100 parts by mass.

Hereinafter, specific examples of stabilizers (stabilizers SS-1 to SS-3) will be described.

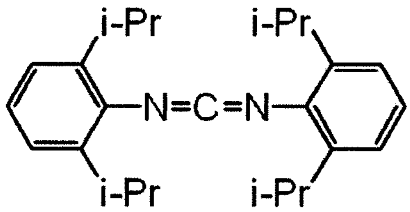

SS-1

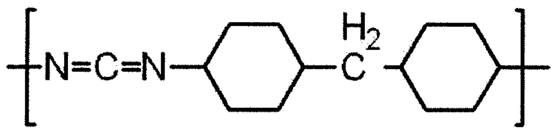

SS-2

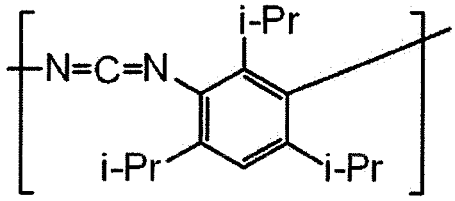

SS-3

Hereinafter, the compound names and commercial products of the stabilizers SS-1 to SS-3 will be described.

Stabilizer SS-1: the compound name is bis-2,6-diisopropylphenylcarbodiimide. The weight-average molecular weight (which is equal to the "molecular weight" in this example) is 363. Examples of commercial products includes STABAXOL I (manufactured by Rhein Chemie Rheinau GmbH) and B2756 (manufactured by Tokyo Chemical Industry Co., Ltd.).

Stabilizer SS-2: the compound name is poly(4,4'-dicyclohexylmethanecarbodiimide). Examples of commercial products with a weight-average molecular weight of about 2000 include CARBODILITE LA-1(manufactured by Nisshinbo Chemical Inc.).

Stabilizer SS-3: the compound name is poly(1,3,5-triisopropylphenylene-2,4-carbodiimide). Examples of commercial products with a weight-average molecular weight of about 3000 include STABAXOL P (manufactured by Rhein Chemie Rheinau GmbH). Examples of commercial products with a weight-average molecular weight of about 20000 include STABAXOL P400 (manufactured by Rhein Chemie Rheinau GmbH).

<Colorant>

The piezoelectric body may contain at least one kind of colorant in order to adjust the color tone.

As the colorant, a colorant described in paragraphs 0164 to 0178 of PCT International Publication No. WO 2014/168188 may be used.

As the colorant, for example, a bluing agent is used to correct a yellowish tint.

With respect to the bluing agent, description in paragraphs 0172 to 0190 of JP-A No. 2013-227547 may be referred to appropriately.

In a case in which the crystalline polymeric piezoelectric body contains the bluing agent, the content of the

bluing agent is preferably from $0.1\times10^{-4}$ to $100.0\times10^{-4}$ parts by mass with respect to 100 parts by mass of the piezoelectric body, and more preferably from $0.3\times10^{-4}$ to $70.0\times10^{-4}$ parts by mass.

In a case in which the piezoelectric body contains the bluing agent, there is no particular limitation on the timing or the method of addition of the bluing agent.

Examples of the method of addition include a method by which the bluing agent is directly mixed or kneaded in a polymer (for example, the optically active polymer) so as to be a predetermined concentration, and a method by which a masterbatch prepared in advance by mixing the bluing agent at a high concentration is blended with a polymer (for example, the optically active polymer) so as to be a predetermined concentration.

As the bluing agent, a colorant (pigment or dye) exhibiting a blue or violet color by absorbing orange to yellow light may be used, and among others a colorant (preferably a dye) with a maximum absorption wavelength of from 520 nm to 600 nm (preferably from 540 nm to 580 nm) is more preferable.

Examples of a dye with a maximum absorption wavelength of from 520 nm to 600 nm include, a monoazo dye represented by Generic Name: Solvent Violet 21, a triarylmethane dye represented by Generic Name: Solvent Blue 2 [CA No. (Color Index No.) 42563], a phthalocyanine dye represented by Generic Name: Solvent Blue 25 [CA No. 74350], an anthraquinone dye represented by Generic name: Solvent Violet 13 [CA No. 60725], Generic Name: Solvent Violet 36, and Generic Name: Solvent Blue 97; cobalt blue, alkali blue, Victoria blue lake, phthalocyanine blue, metal-free phthalocyanine blue, partially chlorinated phthalocyanine blue, Fast Sky blue, and indanthrene blue BC.

Among them, an anthraquinone dye is preferable because of easy availability.

As the anthraquinone dye, preferable are Generic Name: Solvent Violet 13 ("MACROLEX VIOLET B" manufactured by LANXESS); Generic Name: Solvent Violet 36 ("MACROLEX VIOLET 3R" manufactured by LANXESS); Generic Name: Solvent Blue 97 ("MACROLEX BLUE RR" manufactured by LANXESS); KAYASET BLUE FR (manufactured by Nippon Kayaku Co., Ltd.); KAYASET BLUE N (manufactured by Nippon Kayaku Co., Ltd.); KAYASET BLUE 814 (manufactured by Nippon Kayaku Co., Ltd.), and FS BLUE 1504 (manufactured by Arimoto Chemical Co., Ltd.).

<Other Components>

The crystalline polymeric piezoelectric body of the invention may contain other components, if necessary.

Examples of other components include publicly known resins such as polyvinylidene fluoride, a polyethylene resin, and a polystyrene resin; inorganic fillers, such as silica, hydroxyapatite, and montmorillonite; publicly known crystal nucleating agents such as phthalocyanine; and stabilizers other than the stabilizers described above.

Examples of the inorganic fillers and crystal nucleating agents may include components described in paragraphs 0057 to 0058 of PCT International Publication No. WO 2013/054918.

Although there is no particular limitation on the shape of the crystalline polymeric piezoelectric body (piezoelectric body), a film shape is preferable.

Although there is no particular limitation on the thickness of the piezoelectric body, it is preferably from 10 μm to 400 μm, more preferably from 20 μm to 200 μm, still more preferably from 20 μm to 100 μm, and particularly preferably from 20 μm to 80 μm.

In the piezoelectric body described above, the ratio of an acrylic terminal of a polymer contained in the piezoelectric body is preferably regulated from the viewpoints of enhancement of adhesion between the piezoelectric body and the surface layer and enhancement of moist heat resistance and tear strength of the piezoelectric body.

More specifically, in a case in which a $^{1}$H-NMR spectrum is measured with respect to a solution prepared by dissolving 20 mg of the piezoelectric body in 0.6 mL of deuterated chloroform, and then, based on the measured $^{1}$H-NMR spectrum, the ratio of an acrylic terminal of a polymer contained in the piezoelectric body is determined according to the following Formula (X), the ratio of the acrylic terminal of the polymer is preferably from $2.0\times10^{-5}$ to $10.0\times10^{-5}$.

Formula (X): Ratio of acrylic terminal of the polymer = Integral value of peak derived from acrylic terminal of the polymer / Integral value of peak derived from methines in main chain of the polymer

Here, an acrylic terminal may be reworded as an acryloyl group.

Furthermore, an integral value of a peak derived from an acrylic terminal of the polymer means an average value of the integral values of peaks derived respectively from 3 protons of the acrylic terminal (acryloyl group).

In a case in which a polymer contained in the piezoelectric body is a polymer having a main chain including a repeating unit represented by the Formula (1) described below, the acrylic terminal is conceivably formed by breakage of a bond between an oxygen atom (O) in an ether bond (-O-) and a carbon atom (C) in a methine (CH) in a repeating

unit represented by the Formula (1) described above caused by active energy ray (for example, ultraviolet ray) irradiation, heat (for example, a melt-knead process in producing the piezoelectric body), and the like (namely, by a decrease in the molecular weight of the polymer due to degradation). Further, it is believed that a carboxy group (COOH) is formed concurrently with the acrylic terminal.

When the ratio of the acrylic terminal of the polymer is $2.0\times10^{-5}$ or more, adherence between the piezoelectric body and the surface layer is further improved. Although the reason behind the above is not clear, the inventors presume as follows. When the ratio is $2.0\times10^{-5}$ or more, the acrylic terminal of the polymer and a reactive group of the surface layer react to form a sufficient number of chemical bonds, which contribute effectively to improvement of the adherence.

Meanwhile, when the ratio of the acrylic terminal (acryloyl group) of the polymer is $10.0\times10^{-5}$ or less, moist heat resistance and tear strength of the piezoelectric body are further improved. The reason is considered to be that the ratio of $10.0\times10^{-5}$ or less means that polymer degradation caused by active energy ray (for example, ultraviolet ray) irradiation, heat (for example, a melt-knead process in producing the piezoelectric body), and the like is suppressed to a certain degree. In other words, the amount of a carboxy group (COOH), which exerts a negative influence on moist heat resistance, is small, and a decrease in a molecular weight exerting a negative influence on tear strength is suppressed, so that the moist heat resistance and tear strength are presumably improved further.

The ratio of an acrylic terminal of a polymer is more preferably $3.0\times10^{-5}$ or more, still more preferably $4.0\times10^{-5}$ or more, still more preferably $5.0\times10^{-5}$ or more, and particularly preferably $6.0\times10^{-5}$ or more.

Meanwhile, the ratio of an acrylic terminal of a polymer is more preferably $9.0\times10^{-5}$ or less, and still more preferably $8.0\times10^{-5}$ or less.

An example of Formula (X) is an example in which the integral value of a peak derived from the acrylic terminal of the polymer is an average value ($I_{5.9\text{-}6.4}$) of integral values of peaks included in the region of $\delta$ 5.9-6.4 ppm, the integral value of a peak derived from methines in a main chain of the polymer is an integral value ($I_{5.1}$) of a peak at a position of $\delta$ 5.1 ppm, and the ratio of the acrylic terminal of the polymer is a ratio [$I_{5.9\text{-}6.4}/I_{5.1}$].

In the example, in the region of $\delta$ 5.9-6.4 ppm, peaks derived from 3 protons in the acrylic terminal (acryloyl group) respectively appear. The average value ($I_{5.9\text{-}6.4}$) of integral values is an average value of integral values of the respective peaks that appear.

The $^1$H-NMR spectrum is measured by a proton single pulse method under the following conditions.

- Measuring Conditions for $^1$H-NMR Spectrum -

Measuring apparatus: ECA-500, manufactured by JEOL Ltd., or an equivalent apparatus (proton-nuclear resonance frequency: 500 MHz or more)
Solvent: deuterated chloroform (chloroform-d)
Measuring temperature: room temperature
Pulse angle: 45°
Pulse interval: 6.53 sec
Cumulated number: 512 or more

<Production of Piezoelectric Body>

There is no particular limitation on the method of producing a piezoelectric body. Examples of the method include a method by which a film in an amorphous state including the optically active polymer is crystallized and stretched (in any order).

A film in an amorphous state means a film obtained by heating an optically active polymer alone or a mixture containing the optically active polymer at a temperature of a melting point Tm or more of the optically active polymer and then quenching the polymer or the mixture. The quenching temperature is, for example, 50°C.

In the method of producing the piezoelectric body, the optically active polymer (polylactic acid-based polymer etc.) may be used singly, a mixture of two or more kinds of optically active polymers (polylactic acid-based polymer etc.) may be used, or a mixture of at least one kind of optically active polymer described above and at least one kind of other component may be used as a raw material for the piezoelectric body (or a film in an amorphous state).

The mixture is preferably a mixture obtained by melt-kneading.

Specifically, for example, in a case in which two or more kinds of optically active polymers are mixed, or at least one kind of optically active polymer and another component (for example, the inorganic filler or the crystal nucleating agent) are mixed, optically active polymers to be mixed (according to need, together with another component) are melt-kneaded in a melt-kneading machine (LABO PLASTOMIXER, manufactured by Toyo Seiki Seisaku-sho, Ltd.) under conditions of the mixer rotating speed of from 30 rpm to 70 rpm at 180°C to 250°C for 5 minutes to 20 minutes to obtain

a blend of a plurality of kinds of optically active polymers, or a blend of the optically active polymer and another component such as an inorganic filler.

Further, the piezoelectric body can be produced by a production method including a step of stretching a film containing the optically active polymer (preferably a film in an amorphous state) mainly in a uniaxial direction and a step of an annealing treatment in which the stretched film is annealed, in this order.

[Use of Layered Body]

The layered body according to the invention can be used in various fields including a speaker, a headphone, a touch panel, a remote controller, a microphone, a hydrophone, an ultrasonic transducer, an ultrasonic applied measurement instrument, a piezoelectric vibrator, a mechanical filter, a piezoelectric transformer, a delay unit, a sensor, an acceleration sensor, an impact sensor, a vibration sensor, a pressure-sensitive sensor, a tactile sensor, an electric field sensor, a sound pressure sensor, a display, a fan, a pump, a variable-focus mirror, a sound insulation material, a soundproof material, a keyboard, acoustic equipment, information processing equipment, measurement equipment, and a medical appliance.

For example, the layered body of the invention further includes an electrode unit, and can be used favorably as a piezoelectric device having the piezoelectric body, the surface layer, and the electrode unit in this order.

In this case, the piezoelectric body is preferably used as a piezoelectric element having at least two planes, in which one plane (the plane having at least a surface layer) and the other plane are provided with electrodes.

It is enough when the electrodes are provided on at least two planes of the piezoelectric body. There is no particular limitation on the material of the electrode, and examples thereof to be used include Al, Cu, Ag, an Ag paste, ITO (crystallized or amorphous ITO), ZnO, IZO (registered trademark), an electroconductive polymer, a metal nanowire, a metal mesh, carbon black, a carbon nanotube, and graphene.

In a case in which an ITO electrode is formed on the piezoelectric body, an ITO electrode with few defects can be formed by forming a surface layer on the piezoelectric body, and then forming an ITO electrode on the surface layer, so as to relax thermal deformation of the piezoelectric body during ITO crystallization by the surface layer. Further, a refractive index adjusting layer is formed between the surface layer and the ITO electrode so that the reduction of reflectance, the prevention of pattern see-through, and the reduction of coloration can be achieved.

The piezoelectric body in the invention and an electrode may be piled up one another, so as to have the surface layer interposed between at least some of the piezoelectric bodies and the electrodes, and used as a layered piezoelectric element.

For example, units of an electrode and a layered body provided with surface layers on both planes are piled up recurrently and finally a principal plane of a layered body not covered by an electrode is covered by an electrode.

Specifically, one with 2 recurrent units may be a layered piezoelectric element having an electrode, a surface layer, a piezoelectric body, a surface layer, an electrode, a surface layer, a piezoelectric body, a surface layer, and an electrode in this order.

With respect to piezoelectric bodies to be used for the layered piezoelectric element, one layer of a piezoelectric body and one layer of a surface layer may be the layered body of the invention, and the other layers may not be a surface layer and a piezoelectric body of the layered body of the invention.

In a case in which a plurality of piezoelectric bodies is included in the layered piezoelectric element, when an optically active polymer contained in a piezoelectric body in one layer has L-form optical activity, an optically active polymer contained in a piezoelectric body in another layer may be either of L-form or D-form. The location of the piezoelectric body may be adjusted appropriately according to the use of the piezoelectric element.

Particularly, in a case in which a principal plane of a layered body is provided with an electrode, it is preferable to provide a transparent electrode. Here, a transparent electrode specifically means that its internal haze is 40% or less (total light transmittance is 60% or more).

The piezoelectric element using the layered body of the invention may be applied to various piezoelectric devices including a speaker and a touch panel. Particularly, a piezoelectric element provided with a transparent electrode is favorable for applications, such as a speaker, a touch panel, and an actuator.

## EXAMPLES

Hereinafter, the invention will be described more specifically with reference to Examples. However, the invention is not limited to the following Examples as long as it does not depart from the gist of the invention.

[Example 1]

<Production of Piezoelectric Body (P1)>

To 100 parts by mass of polylactic acid (product name: INGEOTM biopolymer, Grade No.: 4032D, manufactured by NatureWorks LLC), 1.0 part by mass of a stabilizer which was a mixture of 10 parts by mass of STABAXOL P400 (manufactured by Rhein Chemie Rheinau GmbH), 70 parts by mass of STABAXOL I (manufactured by Rhein Chemie Rheinau GmbH), and 20 parts by mass of CARBODILITE LA-1 (manufactured by Nisshinbo Chemical Inc.) was added, followed by dry blending to prepare a raw material.

The prepared raw material was charged into a hopper of an extruder, which was then extruded with heating at 210°C through a T-die and brought into contact with a cast roll at 50°C for 0.3 minute to form a 150 μm-thick pre-crystallized film (pre-crystallization step). The crystallinity of the pre-crystallized film was measured and it was 6%.

Uniaxial stretching of the produced pre-crystallized film was started at a stretching speed of 10 m/min by roll-to-roll with heating at 70°C and continued up to 3.5-fold in the MD direction (stretching step). The thickness of the resulting uniaxially stretched film was 49.2 μm.

Then, the uniaxially stretched film was contacted with a roll heated to 145°C for 15 seconds by roll-to-roll to perform an annealing treatment, and thereafter quenched to produce a piezoelectric body (P1) which was the crystalline polymeric piezoelectric body (piezoelectric body) (annealing treatment step).

<Measurement of Amounts of L-Form and D-Form of Polylactic Acid>

Into a 50 mL Erlenmeyer flask, 1.0 g of a weighed-out sample (piezoelectric body) was charged, to which 2.5 mL of IPA (isopropyl alcohol) and 5 mL of a 5.0 mol/L sodium hydroxide solution were added, and a sample solution was prepared. The Erlenmeyer flask containing the sample solution was then placed in a water bath at a temperature of 40°C, and stirred for about 5 hours until polylactic acid was completely hydrolyzed.

After the sample solution was cooled down to room temperature, 20 mL of a 1.0 mol/L hydrochloric acid solution was added for neutralization, and the Erlenmeyer flask was stoppered tightly and stirred well. 1.0 mL of the sample solution was dispensed into a 25 mL measuring flask and diluted with a mobile phase described below to prepare an HPLC sample solution 1 (25 mL). Into an HPLC apparatus, 5 μL of the HPLC sample solution 1 was injected, and D/L-form peak areas of polylactic acid were determined under the following HPLC conditions. Thus, the amounts of L-form and D-form were calculated. Based on the obtained results, the optical purity (% ee) was calculated. The results are shown in Table 1 below.

In the following Table 1, "LA" stands for polylactic acid.

- HPLC Measuring Conditions -

Column: optical resolution column, SUMICHIRAL OA5000 (manufactured by Sumika Chemical Analysis Service, Ltd.)
Measuring apparatus: liquid chromatography (manufactured by JASCO Corporation)
Column temperature: 25°C
Mobile phase: 1.0 mM-copper (II) sulfate buffer solution/IPA=98/2 (V/V);

$$\text{Copper(II) sulfate/IPA/water} = 156.4\ \text{mg}/20\ \text{mL}/980\ \text{mL}$$

Mobile phase flow rate: 1.0 mL/min
Detector: Ultraviolet detector (UV 254 nm)

<Weight-Average Molecular Weight and Molecular Weight Distribution of Polylactic Acid>

The weight-average molecular weight (Mw) and the molecular weight distribution (Mw/Mn) ofpolylactic acid contained in the piezoelectric body P1 were measured using gel permeation chromatograph (GPC) by the following GPC measuring method. The results are shown in Table 1 below.

- GPC Measuring Method -

Measuring apparatus: GPC-100, manufactured by Waters Corp.
Column: SHODEX LF-804, manufactured by Showa Denko K.K.
Preparation of sample: the piezoelectric body P1 was dissolved in a solvent (chloroform) at 40°C to prepare a sample solution with a concentration of 1 mg/mL.
Measuring condition: a sample solution (0.1 mL) was introduced into a column at a temperature of 40°C and a flow rate of 1 mL/min by using a solvent (chloroform). The concentration of the sample in the sample solution separated by the column was measured by a differential refractometer. The weight-average molecular weight (Mw) of a polymer was calculated based on a universal calibration curve created using a polystyrene standard sample.

<Physical Property Measurement and Evaluation of Piezoelectric Body>

With respect to the piezoelectric body P1, the melting point Tm, crystallinity, and standardized molecular orientation MORc were measured as follows.
The results are shown in Table 1 below.

- Melting Point Tm and Crystallinity -

10 mg of the piezoelectric body P1 was weighed accurately and measured by a differential scanning calorimeter (DSC-1, manufactured by Perkin Elmer Inc.) at a temperature increase rate of 10°C/min and a melting endothermic curve was obtained. From the obtained melting endothermic curve, the melting point Tm and crystallinity were obtained.

- Standardized Molecular Orientation MORc -

The standardized molecular orientation MORc of the piezoelectric body P1 was measured by a microwave molecular orientation meter MOA-6000, manufactured by Oji Scientific Instruments. The reference thickness tc was set at 50 μm.

Table 1

| | Piezoelectric body P1 |
|---|---|
| Polymer | LA |
| Chirality | L |
| Mw | 200,000 |
| Mw / Mn | 1.87 |
| Optical purity (%ee) | 97.0 |
| Tm (°C) | 165.4 |
| Crystallinity (%) | 41.8 |
| MORc [50μm] | 4.72 |
| MORc × Crystallinity | 197 |

<Formation of Surface Layer>

An antistatic hard coat coating material (SEPLEGYDA (registered trademark) HC-A, manufactured by Shin-Etsu Polymer Co., Ltd.) was coated on one plane of the piezoelectric body P1 with an applicator, dried at 60°C for 5 minutes, and then irradiated with ultraviolet ray (with an accumulated light amount of 1,000 $mJ/cm^2$) from a metal halide lamp, and thus a surface layer was formed on one plane of the piezoelectric body P1.
Here, SEPLEGYDA (registered trademark) HC-A is an antistatic hard coat coating material which contains an electroconductive polymer as the electroconductive material (A) (polythiophene derivative) and a (meth)acrylic compound as the precursor of the polymer (B).
The formed surface layer includes an electroconductive polymer (polythiophene derivative) as the electroconductive material (A) and a polymer having a three-dimensionally cross-linked structure which is obtained by polymerizing a (meth)acrylic compound as the polymer (B).

The content of the electroconductive polymer (polythiophene derivative) in the obtained surface layer is 1% by mass with respect to the total amount of the surface layer.

Further, a surface layer was formed on the other plane of the piezoelectric body P1, similarly to the one plane.

As described above, a layered body of Example 1 having a layered structure of surface layer/piezoelectric body P1/surface layer was obtained.

<Physical Property Measurement and Evaluation of Layered Body>

Physical property measurement and evaluation of the layered body were carried out as follows.

The results are shown in Table 2 below.

- Thickness of Surface Layer -

The thickness of the surface layer of the layered body was measured by the above-described measurement method using a digital length measuring machine DIGIMICRO STAND MS-11C, manufactured by Nikon Corporation.

- Surface Resistivity of Surface Layer -

The surface resistivity of the surface layer of the layered body was measured using a resistivity meter (Hiresta UX MCP-HT800, manufactured by Mitsubishi Chemical Analytech Co., Ltd.) in accordance with ASTM D257.

- Measurement of Ratio of Acrylic Terminal of Polymer Contained in Piezoelectric Body -

A piezoelectric body was obtained by removing the surface layer from the layered body by grinding the surface layer side of the layered body with a sand paper until the thickness of the object to be ground became equal to the thickness of the piezoelectric body alone.

With respect to the obtained piezoelectric body, the acrylic terminal ratio of a polymer contained in the piezoelectric body was measured. The details will be described below.

A 20 mg-sample was taken from the piezoelectric body obtained by removing the surface layer, and dissolved in 0.6 mL of deuterated chloroform (chloroform-d) to obtain a sample solution for $^1$H-NMR spectrum measurement.

A $^1$H-NMR spectrum was measured on the obtained sample solution under the following measuring conditions.

- Measuring Conditions for $^1$H-NMR Spectrum -

Measuring apparatus: ECA-500, manufactured by JEOL Ltd., (proton-nuclear resonance frequency: 500 MHz)
Solvent: deuterated chloroform (chloroform-d)
Measuring temperature: room temperature
Pulse angle: 45°
Pulse interval: 6.53 sec
Cumulated number: 512

In the measured $^1$H-NMR spectrum, peaks derived from 3 protons in an acrylic terminal (acryloyl group) were observed at positions of $\delta$ 5.9 ppm, $\delta$ 6.1 ppm, and $\delta$ 6.4 ppm in a high resolution, and a peak derived from protons of methines in a main chain of a polymer was observed at a position of $\delta$ 5.1 ppm in a high resolution.

Next, an average value of integral values of the respective peaks at $\delta$ 5.9 ppm, $\delta$ 6.1 ppm, and $\delta$ 6.4 ppm was determined as the integral value of the peak derived from the acrylic terminal of the polymer. Further, an integral value of the peak at $\delta$ 5.1 ppm was determined as the integral value of the peak derived from methines in a main chain of the polymer.

The ratio of the acrylic terminal (acryloyl group) of the polymer contained in the piezoelectric body (the crystalline polymeric piezoelectric body) was calculated based on the results according to the above Formula (X).

The results are shown in Table 2 below.

- Piezoelectric Constant $d_{14}$ of Layered Body (Stress-Electric Charge Method)-

The layered body was cut into a size of 150 mm in a direction of 45° with respect to the stretching direction of the piezoelectric body P1 (MD direction), and 50 mm in the direction perpendicular to the 45°direction, to prepare a rectangular specimen.

Next, the obtained specimen was set on a stage of SIP-600 from Showa Shinku Co., Ltd. and Al was deposited on one plane of the specimen so as to give a deposited Al thickness of about 50 nm. Then, Al was deposited similarly on the other plane of the specimen. Thus, Al electroconductive layers were formed on both planes of the specimen.

A specimen of 150 mmx50 mm with the Al electroconductive layers on both planes was cut into a size of 120 mm in a direction of 45° with respect to the stretching direction (MD direction) of the piezoelectric body P1 and 10 mm in the direction perpendicular to the 45°direction, and thus a rectangular film in a size of 120 mmx 10 mm was cut out. This film was used as a sample for measuring the piezoelectric constant.

The obtained sample was set on a tensile testing machine (TENSILON RTG-1250, manufactured by A&D Company Ltd.) in which a distance between chucks was set to 70 mm so as not to loosen. A force was cyclically applied to the sample at a crosshead speed of 5 mm/min such that an applied force reciprocated between 4N and 9N. On this occasion, in order to measure the amount of electric charge generated on the sample corresponding to the applied force, a capacitor with the capacitance Qm (F) was connected in parallel to the sample, and an interterminal voltage Vm of the capacitor Cm (95 nF) was measured with a buffer amplifier. A generated electric charge amount Q (C) was calculated as a product of capacitance Cm and interterminal voltage Vm.

The piezoelectric constant $d_{14}$ was calculated according to the following Formula.

$$d_{14} = (2\times t)/L\times Cm\cdot \Delta Vm/\Delta F$$

t: sample thickness (m)
L: distance between chucks (m)
Cm: capacitance of capacitor connected in parallel (F)
$\Delta Vm/\Delta F$: ratio of change in interterminal voltage of capacitor to change in force

- Total Haze of Layered Body -

The total haze (%) in the thickness direction of the layered body was measured using the following apparatus under the following measuring conditions.

Measuring apparatus: HAZE METER (TC-H III DPK, manufactured by Tokyo Denshoku Co., Ltd.)
Sample size: 30 mm (width) × 30 mm (length)
Measuring condition: in accordance with JIS-K7136 (2000)
Measuring temperature: room temperature (25°C)

- Total Light Transmittance of Layered Body -

The total light transmittance (%) in the thickness direction of the layered body was measured using the same apparatus and conditions as the apparatus and conditions used to measure the total haze of the layered body in accordance with JIS7361-1 (1999).

- Internal Haze of Layered Body -

The internal haze of the layered body (hereinafter also referred to as "internal haze (H1)") was obtained by the following method.

First, the haze (H2) was measured by placing in advance only a silicone oil (Shin-Etsu Silicone (trade mark), grade: KF96-100CS; manufactured by Shin-Etsu Chemical Co., Ltd.) between two glass plates. Then, the haze (H3) was measured by placing the piezoelectric body, of which surfaces were wetted uniformly with the silicone oil, between the two glass plates. After that, the internal haze (H1) of the layered body was obtained by calculating the difference between the above hazes according to the following formula.

$$\text{Internal haze (H1)} = \text{haze (H3)} - \text{haze (H2)}$$

The haze (H2) and haze (H3) were measured similarly to the total haze of the layered body.

- Internal Light Transmittance of Layered Body -

During measurement of the internal haze of the layered body, the light transmittance (T2), instead of the haze (H2), was measured in measurement of the haze (H2), and the light transmittance (T3), instead of the haze (H3), was measured in measurement of the haze (H3). After that, the internal light transmittance (T1) of the layered body was obtained by calculating the difference between them according to the following formula.

$$\text{Internal light transmittance (T1)} = \text{light transmittance (T3)} - \text{light transmittance (T2)}$$

- Evaluation of Antistatic Properties (Adhesion of Ashes) -

The surface of the layered body was rubbed with a rubber roller several times at 23°C and 20%RH. The rubbed surface was turned upward, cigarette ashes were dropped on the surface so as to be adhered thereto. After that, the rubbed surface with cigarette ashes thereon was turned downward and an ash adhered state was observed. Based on the observation results, the antistatic properties of the layered body were evaluated according to the following evaluation criteria.

"A" in the following evaluation criteria indicates excellent antistatic properties.

- Evaluation Criteria of Antistatic Properties -

A: all the cigarette ashes fell down after the rubbed surface was turned downward;
B: almost all the cigarette ashes fell down after the rubbed surface was turned downward; and
C: although the rubbed surface was turned downward, almost all the cigarette ashes did not fall down and were still adhered.

- Scratch Resistance of Layered Body -

The scratch resistance of the layered body was evaluated by the following method.

The surface of the layered body was rubbed by moving thereon #0000 steel wool back and forth 10 times at a load of 500 g/cm$^2$, and then the presence of scratches was determined by transmission and reflection.

-- Evaluation Criteria of Scratch Resistance --

A: No scratches were formed on the surface;
B: Scratches were hardly formed on the surface; and
C: Many scratches were formed on the surface.

- Adherence Between Piezoelectric Body and Surface Layer-

Six cut lines were made in the surface layer of the layered body with a cutter knife from above at 2 mm intervals in a longitudinal direction and a cross direction respectively to form 25 grid patterns in a size of 2 mm square, then a cellophane adhesive tape (manufactured by Nichiban Co., Ltd.) was stuck tightly thereon. Then, the cellophane adhesive tape was pulled off rapidly by hand. In a case in which no grid patterns were peeled, it was rated "A". In a case in which a part of the patterns was peeled, it was rated "B".

- Moist Heat Resistance of Layered Body -

The layered body was cut into a 50 mm×50 mm square to produce a specimen. Two of the specimens were produced (hereinafter referred to as "specimen 1" and "specimen 2").

With respect to the specimen 1, the molecular weight Mw was measured in the same manner as in the "GPC

measuring method", and the measured value was defined as "Mw before test".

The specimen 2 was suspended in a thermo-hygrostat kept at 85°C and RH85% and maintained in the thermo-hygrostat for 192 hours (written as "192h" in Table 2) or 264 hours (written as "264h" in Table 2) (moist heat resistance test), and then taken out of the thermo-hygrostat. With respect to the taken out specimen 2, the molecular weight Mw was measured in the same manner as in the "GPC measuring method", and the measured value was defined as "Mw after moist heat resistance test".

Based on the Mw before test and the Mw after moist heat resistance test, the moist heat resistance was rated according to the following criteria.

-- Evaluation Criteria of Moist Heat Resistance --

A: Mw after moist heat resistance test/Mw before test = 0.7 or more
B: Mw after moist heat resistance test/Mw before test = less than 0.7 and 0.4 or more
C: Mw after moist heat resistance test/Mw before test = less than 0.4

- Tear Strength of Layered Body -

The tear strength of the layered body was measured as follows.

First, as shown in Fig. 1, a specimen 12 for tear strength measurement (specimen stipulated according to JIS K 7128-3 (1998)) was cut out from a film 10, which was the layered body. In this case, the specimen 12 was cut out, such that the longitudinal direction of the specimen 12 was parallel to the TD direction of the film 10 as shown in Fig. 1.

Next, with respect to the cut-out specimen 12, the tear strength was measured according to a "Right angled tear method" of JIS K 7128-3 (1998) by tearing the specimen 12 at a central part in the longitudinal direction of the specimen 12 in the MD direction of the film.

Here, the crosshead speed of the tensile testing machine was 200 mm/min and the tear strength was calculated according to the following formula.

$$T = F/d$$

(In the formula, T stands for tear strength (N/mm), F stands for maximum tearing load, and d stands for thickness of specimen (mm)).

[Comparative Example 1]

The same operation as Example 1 was performed except that the antistatic hard coat coating material (SEPLEGYDA HC-A, manufactured by Shin-Etsu Polymer Co., Ltd.) was changed to a hard coat coating material (anti-block hard coat LIODURAS (registered trademark) TYAB-014, manufactured by Toyo Ink Co., Ltd.) in Example 1.

The results are shown in Table 2.

Here, TYAB-014 is an anti-block hard coat coating material which does not contain an electroconductive material and contains a (meth) acrylic compound as the precursor of the polymer (B). The surface layer of the layered body in Comparative Example 1 is a surface layer which does not contain the electroconductive material and contains a polymer having a three-dimensionally cross-linked structure formed by polymerizing the (meth) acrylic compound as the polymer (B).

[Comparative Example 2]

The same operation as Example 1 was performed except that the surface layer was not formed in Example 1. In Comparative Example 2, various measurements and evaluations were performed on the piezoelectric body P1 alone.

The results are shown in Table 2.

[Comparative Example 3]

As the piezoelectric body for comparison, a piezoelectric body containing an electroconductive material was produced. The details will be described below.

A polylactic acid solution was produced by dissolving 9.5 g of polylactic acid (4032D described above) in 200 g of chloroform (manufactured by Wako Pure Chemical Industries, Ltd. Industries, Wako first-class quality) at room temperature.

Then, to the polylactic acid solution, 10 g of a polythiophene electroconductive polymer solution (SEPLEGYDA SAS-M05, manufactured by Shin-Etsu Polymer Co., Ltd., solid content concentration: 5% by mass) as a solution of an electroconductive material was added and stirred for 180 minutes. The obtained solution was dried by leaving at 50°C and 0.2 atmospheres for 12 hours and a mixed solid was obtained.

The obtained mixed solid was heat-pressed at 205°C for 1 minute. Then, the mixed solid after the heat press process was pressed with a pressing machine set at 20°C and a quenched film was obtained.

The opposing two sides of the quenched film were fixed with clips. The film was stretched up to 3.3-fold in the direction perpendicular to the two sides with heating at 70°C to form a stretched film. The resulting stretched film was annealed at 130°C for 600 seconds, followed by quenching to form a piezoelectric body containing an electroconductive material.

The same measurement and evaluation as those of Example 1 were performed on the resulting piezoelectric body for comparison (piezoelectric body containing the electroconductive material).

The results are shown in Table 2.

Table 2

| | Surface layer | | | | Piezo electric body | Layered body | | | | | | | | | | |
|---|---|---|---|---|---|---|---|---|---|---|---|---|---|---|---|---|
| | Electro conductive material (A) | Polymer (B) | Thickness | Surface resistivity (Ω/sq) | Ratio of acrylic terminal | Piezo electric constant $d_{14}$ (pC/N) | Total haze (%) | Total light transmittance (%) | Internal haze (%) | Internal light transmittance (%) | Antistatic properties | Scratch resistance | Adherence | Moistheat resistance (192h) | Moistheat resistance (264h) | Tear strength [N/mm] |
| Example 1 | Presence | Presence | Totalon both planes: 8 μm | $3.4\times10^{10}$ | $6.3\times10^{-5}$ | 6.4 | 0.36 | 91.1 | 0.13 | 98.5 | A | A | A | A | A | 43.1 |
| Comparative Example 1 | Absence | Presence | Totalon both planes: 8 μm | $1.3\times10^{14}$ | $6.4\times10^{-5}$ | 5.7 | 0.72 | 91.7 | 0.11 | 99.5 | C | A | A | A | B | 40.7 |
| Comparative Example 2 | Absence of the surface layer | | | Un measurable | $6.2\times10^{-5}$ | 6.4 | 1.50 | 93.2 | 0.13 | 99.8 | C | C | - | A | B | 41.2 |
| Comparative Example 3 | Absence of the surface layer (piezoelectric body containing the electroconductive material) | | | $6.1\times10^{11}$ | $6.3\times10^{-5}$ | 5.5 | 11.31 | 87.2 | 7.41 | 89.5 | A | C | - | B | C | 30.7 |

As shown in Table 2, in the layered body of Example 1 which included the surface layer containing the electroconductive material (A) and the polymer (B), the piezoelectric constant $d_{14}$ was maintained equally, the transparency was also maintained to some extent, and antistatic properties were improved, as compared to Comparative Example 2 (the piezoelectric body P1 alone).

On the other hand, in the layered body of Comparative Example 1 including the surface layer which did not include the electroconductive material (A) and included the polymer (B), the antistatic properties were not improved and a decrease in the piezoelectric constant $d_{14}$ was also observed as compared to Comparative Example 2 (the piezoelectric body alone).

Further, the layered body of Example 1 was excellent in moist heat resistance (264h) as compared to the layered body of Comparative Example 1 and the piezoelectric body P1 of the Comparative Example 2 alone.

The piezoelectric body of Comparative Example 3, which was a piezoelectric body which did not have the surface layer and contained the electroconductive material, was inferior in transparency, scratch resistance, moist heat resistance, and tear strength as compared to the layered body of Example 1.

The disclosure of Japanese Patent Application No. 2014-255014 is incorporated herein by reference in its entirety.

All publications, patent applications, and technical standards mentioned in this specification are herein incorporated by reference to the same extent as if each individual publication, patent application, or technical standard was specifically and individually indicated to be incorporated by reference.

## Claims

1. A layered body comprising:

   a crystalline polymeric piezoelectric body having a standardized molecular orientation MORc of from 2.0 to 10.0 measured by a microwave transmission-type molecular orientation meter based on a reference thickness of 50 $\mu$m; and
   a surface layer which is disposed so that at least a part of the surface layer contacts the crystalline polymeric piezoelectric body, which has a surface resistivity of from $1\times10^6$ $\Omega$/sq to $1\times10^{12}$ $\Omega$/sq, and which contains an electroconductive material (A) and a polymer (B).

2. The layered body according to claim 1, wherein the electroconductive material (A) is an electroconductive polymer, and the polymer (B) is a polymer other than an electroconductive polymer.

3. The layered body according to claim 1 or 2, wherein a content of the electroconductive material (A) in the surface layer is from 0.01% by mass to 30% by mass.

4. The layered body according to claim 2, wherein the electroconductive polymer is at least one polymer selected from the group consisting of polythiophene, polythiophene derivatives, polypyrrole, polypyrrole derivatives, polyaniline, and polyaniline derivatives.

5. The layered body according to any one of claims 1 to 4, wherein a thickness of the surface layer is from 0.01 $\mu$m to 10 $\mu$m.

6. The layered body according to any one of claims 1 to 5, wherein the polymer (B) is a polymer having a three-dimensionally cross-linked structure.

7. The layered body according to any one of claims 1 to 6, wherein an internal haze with respect to visible light is 50% or less, and a piezoelectric constant $d_{14}$ measured at 25°C by a stress-electric charge method is 1 pC/N or more.

8. The layered body according to any one of claims 1 to 7, wherein an internal haze with respect to visible light is 13% or less.

9. The layered body according to any one of claims 1 to 8, wherein a product of the standardized molecular orientation MORc of the crystalline polymeric piezoelectric body and a crystallinity of the crystalline polymeric piezoelectric body obtained by a DSC method is from 40 to 700.

10. The layered body according to any one of claims 1 to 9, wherein the crystalline polymeric piezoelectric body includes

a helical chiral polymer having optical activity and having a weight-average molecular weight of from 50,000 to 1,000,000, and has a crystallinity obtained by a DSC method of from 20% to 80%.

**11.** The layered body according to claim 10, wherein the helical chiral polymer is a polylactic acid-based polymer having a main chain including a repeating unit represented by the following Formula (1):

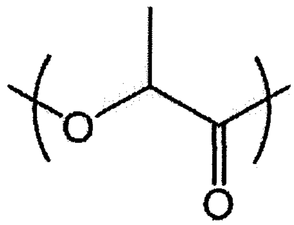

(1)

.

**12.** The layered body according to claim 10 or 11, wherein an optical purity of the helical chiral polymer is 95.00% ee or higher.

**13.** The layered body according to any one of claims 10 to 12, wherein a content of the helical chiral polymer in the crystalline polymeric piezoelectric body is 80% by mass or more.

**14.** The layered body according to any one of claims 10 to 13, wherein the crystalline polymeric piezoelectric body contains a stabilizer having a weight-average molecular weight of from 200 to 60,000 and having at least one functional group selected from the group consisting of a carbodiimide group, an epoxy group, and an isocyanate group, and wherein the stabilizer is contained in an amount of from 0.01 parts by mass to 10 parts by mass with respect to 100 parts by mass of the helical chiral polymer.

**15.** The layered body according to claim 14, wherein the stabilizer has, in a molecule, one functional group selected from the group consisting of a carbodiimide group, an epoxy group, and an isocyanate group.

**16.** The layered body according to any one of claims 1 to 15, wherein the polymer (B) is a polymer of a compound having a (meth)acryloyl group.

**17.** The layered body according to any one of claims 1 to 16, wherein the polymer (B) is an active energy ray-cured resin that has been cured by active energy ray irradiation.

**18.** The layered body according to any one of claims 1 to 17, wherein the polymer (B) is an ultraviolet ray-cured resin that has been cured by ultraviolet ray irradiation.

**19.** The layered body according to any one of claims 1 to 18, wherein a ratio of an acrylic terminal of a polymer contained in the crystalline polymeric piezoelectric body is from $2.0\times10^{-5}$ to $10.0\times10^{-5}$, wherein the ratio of the acrylic terminal of the polymer is determined by the following Formula (X) based on a $^1$H-NMR spectrum measured with respect to a solution obtained by dissolving 20 mg of the crystalline polymeric piezoelectric body in 0.6 mL of deuterated chloroform:

Formula (X) Ratio of acrylic terminal of the polymer = Integral value of peak derived from acrylic terminal of the polymer / Integral value of peak derived from methines in main chain of the polymer.

FIG.1

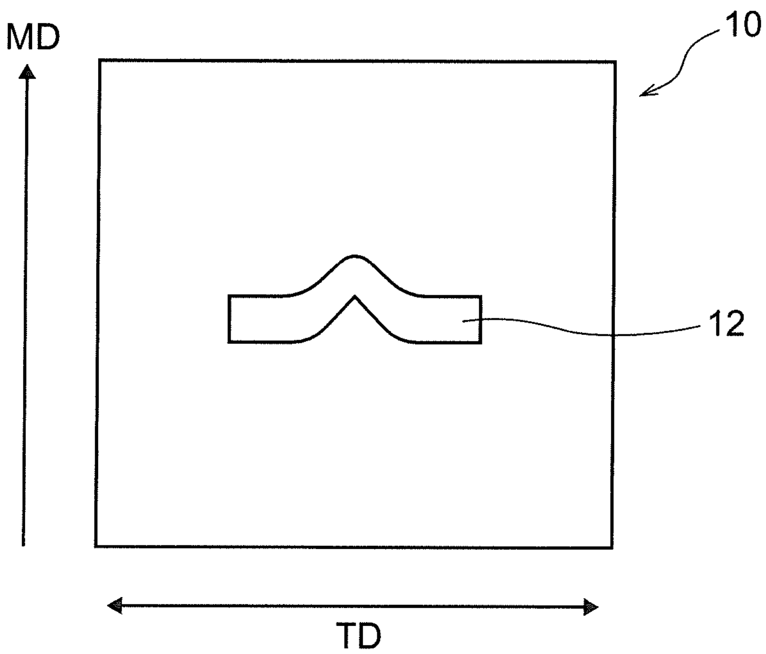

**INTERNATIONAL SEARCH REPORT**

International application No. PCT/JP2015/083918

A. CLASSIFICATION OF SUBJECT MATTER

*B32B7/02*(2006.01)i, *B32B27/18*(2006.01)i, *B32B27/36*(2006.01)i, *H01L41/193*(2006.01)i

According to International Patent Classification (IPC) or to both national classification and IPC

B. FIELDS SEARCHED

Minimum documentation searched (classification system followed by classification symbols)
B32B1/00-43/00, H01L41/00-41/47

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2013/054918 A1 (Mitsui Chemicals, Inc.), 18 April 2013 (18.04.2013), claims; examples & EP 2672539 A1 claims; examples & JP 2013-854918 A & JP 2013-199649 A & US 2014/0084204 A1 & US 2015/0337113 A1 & CN 103380505 A & KR 10-2013-0120505 A & CN 105131541 A | 1-19 |
| A | JP 2014-168132 A (Teijin Ltd.), 11 September 2014 (11.09.2014), claims (Family: none) | 1-19 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 12 February 2016 (12.02.16) | 23 February 2016 (23.02.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H05152638 A
- JP 2005213376 A
- WO 2010143528 PCT
- WO 2014168188 PCT
- JP S59096123 A
- JP H7033861 B
- US 2668182 A
- US 4057357 A
- WO 2013054918 PCT
- US 2941956 A
- JP S4733279 B
- JP 4084953 B
- JP 2011256337 A
- JP 2013227547 A
- JP 2014255014 A


### Non-patent literature cited in the description


- *J. Org. Chem.,* 1963, vol. 28, 2069-2075
- *Chemical Review,* 1981, vol. 81 (4), 619-621